# EUROPEAN PATENT APPLICATION

(11) **EP 4 746 036 A1**
(43) Date of publication of application: **20.05.2026**
(21) Application number: 24213034.2
(22) Date of filing: 14.11.2024
(51) Int. Cl.: H01L 23/00

(54) **METHOD FOR BONDING SEMICONDUCTOR SUBSTRATES**

(71) Applicant: ASML Netherlands B.V., 5500 AH Veldhoven (NL)
(72) Inventor: NIKIPELOV, Andrey, 5500 AH Veldhoven (NL); HSU, Chia-Hao, 5500 AH Veldhoven (NL); DONDERS, Sjoerd, Nicolaas, Lambertus, 5500 AH Veldhoven (NL); STEVENS, Lucas, Henricus, Johannes, 5500 AH Veldhoven (NL); WÖLTGENS, Pieter, Joseph, Marie, 5500 AH Veldhoven (NL); DEENEN, Daniel, Andreas, 5500 AH Veldhoven (NL); KEMKERS, Geert Richard, 5500 AH Veldhoven (NL); STEUR, Michael, Marinus, Anna, 5500 AH Veldhoven (NL)
(74) Representative: ASML Netherlands B.V.

(57) **Abstract**

The present disclosure relates to methods and apparatus for joining a first semiconductor substrate and a second semiconductor substrate. The method may comprise: first pushing the first semiconductor substrate towards an auxiliary member to bring the first semiconductor substrate into contact with the auxiliary member; and then second pushing the second semiconductor substrate towards the first semiconductor substrate and the auxiliary member to cause joining of the first semiconductor substrate and the second semiconductor substrate, wherein the first pushing is substantially the same as the second pushing. Additionally or alternatively, the method may comprise: clamping an auxiliary member to a clamp, wherein the first semiconductor substrate is secured to the auxiliary member; and pushing the auxiliary member away from the clamp and towards the second semiconductor substrate to bring the first semiconductor substrate into contact with the second semiconductor substrate.

## Description

### FIELD OF INVENTION

The present invention relates to methods and apparatus for joining and/or bonding semiconductor substrates.

### BACKGROUND

In the manufacture of integrated circuits (ICs), circuit features are formed on/in semiconductor substrates. To form circuit features on/in a semiconductor substrate, various processes may be performed such as; depositing a layer of photoresist on a surface on the semiconductor substrate; imparting of a pattern to the layer of photoresist using lithography; etching material away from the semiconductor substrate or layers deposited thereon, in accordance with the pattern imparted to the layer of photoresist during lithography; and modifying characteristics of the semiconductor substrate or the layers formed thereon, (e.g. through oxidation, doping, ion implantation, etc.).

To form some types of device, one semiconductor substrate (which has circuit features formed thereon) may be bonded with another semiconductor substrate (which also has circuit features formed therein/thereon). Bonding processes include die-to-die, die-to-wafer and wafer-to-wafer bonding processes. Wafer-to-wafer bonding, where whole wafers are permanently bonded together prior to dicing, has the potential of providing a high accuracy and high throughput bonding solution.

The surfaces of the semiconductor substrate which are bonded together may comprise a plurality of metallic portions. The metallic portions may be configured such that, once the two substrates are bonded together, the two semiconductor substrates are in electrical contact with one another via the metallic portions. Thus, the circuit features of the two semiconductor substrates can operate together.

During bonding, it is desirable that two semiconductor substrates (and, in particular, the metallic portions of the two substrates) are well-aligned. Misalignment of the two semiconductor substrates may mean that the electrical contact between the two semiconductor substrates is not achieved as desired. Moreover, misalignment of the two semiconductor substrates may reduce a strength of the bonding between the two semiconductor substrates.

Misalignment of the metallic portions of the two substrates may be induced by the bonding process itself. For example, as the two semiconductor substrates are brought together during the bonding process, one or both of the semiconductor substrates may become distorted/deformed. The distortion/deformation undergone by one of the two semiconductor substrates may be different to the distortion/deformation undergone by the other of the two semiconductor substrates. Differences in the distortion/deformation undergone by the two semiconductor substrates may result in misalignment between the metallic portions of the two semiconductor substrates.

### SUMMARY OF THE INVENTION

According to a first aspect of the present disclosure is a method for joining a first semiconductor substrate and a second semiconductor substrate. The method may comprise, first pushing the first semiconductor substrate towards an auxiliary member to bring the first semiconductor substrate into contact with the auxiliary member. Then the method may comprise second pushing the second semiconductor substrate towards the first semiconductor substrate and the auxiliary member to cause joining of the first semiconductor substrate and the second semiconductor substrate. The first pushing may be substantially the same as the second pushing.

According to a second aspect of the present disclosure is a system for joining a first semiconductor substrate and a second semiconductor substrate. The system may comprise a first pushing mechanism configured to push the first semiconductor substrate towards an auxiliary member to bring the first semiconductor substrate into contact with the auxiliary member. The system may further comprise a second pushing mechanism configured to push the second semiconductor substrate towards the first semiconductor substrate and the auxiliary member to cause joining of the first semiconductor substrate and the second semiconductor substrate. The first pushing mechanism is substantially the same as the second pushing mechanism.

In the first and second aspects of the present disclosure, by pushing the first and second semiconductor substrates in substantially the same way in the joining process, a distortion induced in the first semiconductor substrate is substantially the same as a distortion inducted in the second semiconductor substrate. Thus, the alignment of the first semiconductor substrate and the second semiconductor substrate (e.g. the alignment of metallic portions of the first semiconductor substrate and the metallic portions of the second semiconductor substrate) is improved.

According to a third aspect of the present disclosure is a method of bonding a first semiconductor substrate and a second semiconductor substrate. The method may comprise clamping an auxiliary member to a clamp, wherein the first semiconductor substrate is secured to the auxiliary member. The method may further comprise pushing the auxiliary member away from the clamp and towards the second semiconductor substrate to bring the first semiconductor substrate into contact with the second semiconductor substrate. During the pushing of the auxiliary member away from the clamp, a perimeter portion of the auxiliary member may remain in contact with the clamp until more than 90% by area of a joining surface of the first semiconductor substrate is in contact with a joining surface of the second semiconductor substrate.

According to a fourth aspect of the present disclosure is a system for use in bonding semiconductor substrates. The system may comprise an auxiliary member configured to support a semiconductor substrate. The system may further comprise a clamp configured to releasably clamp the auxiliary member. The system may further comprise a pushing mechanism configured to push the auxiliary member and the semiconductor substrate supported thereon away from the clamp. A diameter of the auxiliary member may be greater than a diameter of the semiconductor substrate.

In the third and fourth aspects of the present disclosure, as the auxiliary member and the first semiconductor are pushed away from the clamp, the first semiconductor substrate comes mostly in contact with the second semiconductor substrate before an edge of the auxiliary member breaks contact with (e.g. rolls off) the clamp. The point at which the edge of the auxiliary member breaks contact with (e.g. rolls off) the clamp is unpredictable in nature and difficult to control. By ensuring that the first semiconductor substrate and the second semiconductor substrate are already in contact at the point when the edge of the auxiliary member breaks contact with (e.g. rolls off) the clamp, the unpredictable/uncontrollable behavior of the auxiliary member as it breaks contact with (e.g. rolls off) the clamp does not affect the distortion of the first semiconductor substrate. Consequently, unpredictable/uncontrollable behavior of the auxiliary member as it breaks contact with (e.g. rolls off) the clamp does not worsen the alignment between the first semiconductor substrate and the second semiconductor substrate (e.g. the alignment between metallic portions of the first semiconductor substrate and metallic portions of the second semiconductor substrate).

Further aspects, features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

Embodiments of the invention will now be described, by way of example, with reference to the accompanying drawings which are briefly described below.
Figure 1 depicts a lithographic apparatus together with other apparatuses forming a production facility for semiconductor devices.
Figure 2 is a diagram describing a present method of manufacturing integrated devices which utilizes the bonding of substrates.
Figure 3 schematically depicts a hybrid bonding process.
Figure 4A depicts the steps of a conventional bonding method. Figure 4B depicts the alignment of metallic portions of the two substrates at various stages of the conventional bonding method.
Figure 5A depicts a first portion of a bonding method in accordance with a first embodiment. Figure 5B depicts the alignment of the metallic portions of the two substrates during the steps depicted in Figure 5A.
Figure 6A depicts a second portion of the bonding method in accordance with the first embodiment. Figure 6B depicts the alignment of the metallic portions of the two substrates during the steps depicted in Figure 6A.
Figure 7A depicts a modified version of the second portion of the bonding method in accordance with the first embodiment. Figure 7B depicts the alignment of the metallic portions of the two substrates during the steps depicted in Figure 7A.
Figure 8A depicts a first portion of a bonding method in accordance with a second embodiment. Figure 8B depicts the alignment of the metallic portions of the two substrates during the steps depicted in Figure 8A.
Figure 9A depicts a second portion of the bonding method in accordance with the second embodiment. Figure 9B depicts the alignment of the metallic portions of the two substrates during the steps depicted in Figure 9B
Figure 10 depicts a modified version of the bonding method in accordance with the second embodiment
Figures 11A-11E each depict a substrate bonded to an auxiliary member. The auxiliary member depicted in 11A-11E is configured to allow for the removal of the substrate from the auxiliary member.
Figures 12A-12D each depict a clamp which is configured a clamp a bonding surface of a substrate without causing damage to the bonding surface of the substrate.
Figures 13A and 13B depict perspective views of a clamp having some of the features depicted in Figures 12A-12D.
Figure 14 depicts an example manufacturing setup for the bonding method according to the second embodiment of the present disclosure.
Figure 15 depicts example manufacturing setup for the bonding method according to the modified version of the second embodiment of the present disclosure.
Figure 16 depicts a bonding method in accordance with a third embodiment.
Figure 17 depicts an arrangement for performing the method according to the third embodiment, wherein alignment marks are provided on the substrate and the auxiliary member.
Figure 18 depicts an arrangement for performing the method according to the third embodiment, wherein mechanical compensation is provided on the auxiliary member.
Figures 19A-19B depict an arrangement for performing the bonding method according to the third embodiment, wherein actuators are provided on the auxiliary member.

### DETAILED DESCRIPTION

Before describing embodiments of the invention in detail, it is instructive to present an example environment in which embodiments of the present invention may be implemented.

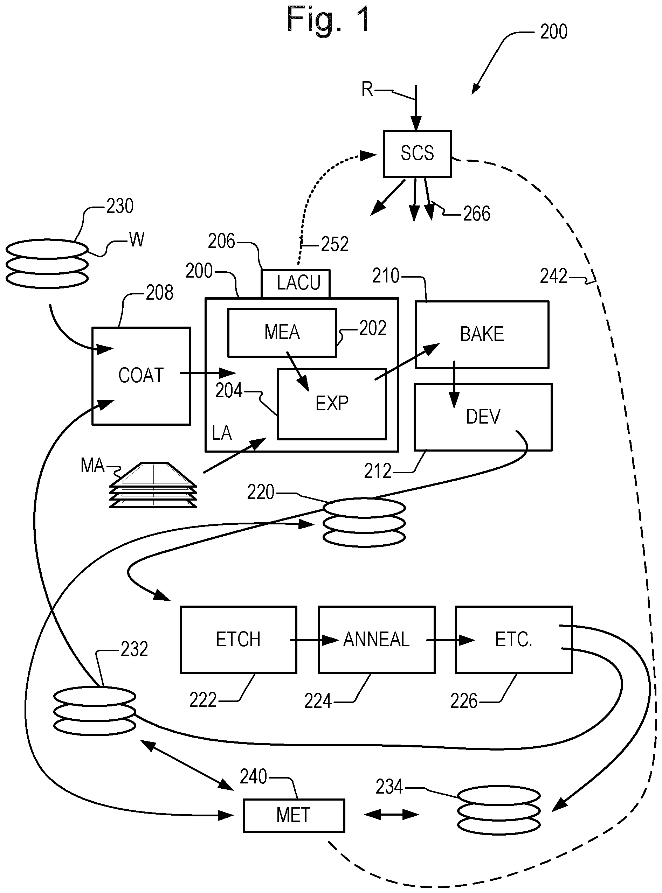

Figure 1 at 200 shows a lithographic apparatus LA as part of an industrial production facility implementing a high-volume, lithographic manufacturing process. In the present example, the manufacturing process is adapted for the manufacture of semiconductor products (integrated circuits) on semiconductor substrates (e.g. semiconductor wafers). The skilled person will appreciate that a wide variety of products can be manufactured by processing different types of substrates in variants of this process. The production of semiconductor products is used purely as an example which has great commercial significance today.

Within the lithographic apparatus (or "litho tool" for short), a measurement station MEA is shown at 202 and an exposure station EXP is shown at 204. A control unit LACU is shown at 206. In this example, each substrate visits the measurement station and the exposure station to have a pattern applied. In an optical lithographic apparatus, for example, a projection system is used to transfer a product pattern from a patterning device MA onto the substrate using conditioned radiation and a projection system. This is done by forming an image of the pattern in a layer of radiation-sensitive resist material.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. The patterning MA device may be a mask or reticle, which imparts a pattern to a radiation beam transmitted or reflected by the patterning device. Well-known modes of operation include a stepping mode and a scanning mode. As is well known, the projection system may cooperate with support and positioning systems for the substrate and the patterning device in a variety of ways to apply a desired pattern to many target portions across a substrate. Programmable patterning devices may be used instead of reticles having a fixed pattern. The radiation for example may include electromagnetic radiation in the deep ultraviolet (DUV) or extreme ultraviolet (EUV) wavebands. The present disclosure is also applicable to other types of lithographic process, for example imprint lithography and direct writing lithography, for example by electron beam.

The lithographic apparatus control unit LACU which controls all the movements and measurements of various actuators and sensors to receive substrates W and reticles MA and to implement the patterning operations. LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus.

Before the pattern is applied to a substrate at the exposure station EXP, the substrate is processed in at the measurement station MEA so that various preparatory steps may be carried out. The preparatory steps may include mapping the surface height of the substrate using a level sensor and measuring the position of alignment marks on the substrate using an alignment sensor. The alignment marks are arranged nominally in a regular grid pattern. However, due to inaccuracies in creating the marks and also due to deformations of the substrate that occur throughout its processing, the marks deviate from the ideal grid. Consequently, in addition to measuring position and orientation of the substrate, the alignment sensor in practice must measure in detail the positions of many marks across the substrate area, if the apparatus is to print product features at the correct locations with very high accuracy. The apparatus may be of a so-called dual stage type which has two substrate tables, each with a positioning system controlled by the control unit LACU. While one substrate on one substrate table is being exposed at the exposure station EXP, another substrate can be loaded onto the other substrate table at the measurement station MEA so that various preparatory steps may be carried out. The measurement of alignment marks is therefore very time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. Lithographic apparatus LA may for example is of a so-called dual stage type which has two substrate tables and two stations - an exposure station and a measurement station- between which the substrate tables can be exchanged.

Within the production facility, apparatus 200 forms part of a "litho cell" or "litho cluster" that contains also a coating apparatus 208 for applying photosensitive resist and other coatings to substrates W for patterning by the apparatus 200. At an output side of apparatus 200, a baking apparatus 210 and developing apparatus 212 are provided for developing the exposed pattern into a physical resist pattern. Between all of these apparatuses, substrate handling systems take care of supporting the substrates and transferring them from one piece of apparatus to the next. These apparatuses, which are often collectively referred to as the track, are under the control of a track control unit which is itself controlled by a supervisory control system SCS, which also controls the lithographic apparatus via lithographic apparatus control unit LACU. Thus, the different apparatus can be operated to maximize throughput and processing efficiency. Supervisory control system SCS receives recipe information R which provides in great detail a definition of the steps to be performed to create each patterned substrate.

Once the pattern has been applied and developed in the litho cell, patterned substrates 220 are transferred to other processing apparatuses such as are illustrated at 222, 224, 226. A wide range of processing steps is implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc.. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses. As another example, apparatus and processing steps may be provided for the implementation of self-aligned multiple patterning, to produce multiple smaller features based on a precursor pattern laid down by the lithographic apparatus.

As is well known, the manufacture of semiconductor devices involves many repetitions of such processing, to build up device structures with appropriate materials and patterns, layer-by-layer on the substrate. Accordingly, substrates 230 arriving at the litho cluster may be newly prepared substrates, or they may be substrates that have been processed previously in this cluster or in another apparatus entirely. Similarly, depending on the required processing, substrates 232 on leaving apparatus 226 may be returned for a subsequent patterning operation in the same litho cluster, they may be destined for patterning operations in a different cluster, or they may be finished products to be sent for dicing and packaging.

Each layer of the product structure requires a different set of process steps, and the apparatuses 226 used at each layer may be completely different in type. Further, even where the processing steps to be applied by the apparatus 226 are nominally the same, in a large facility, there may be several supposedly identical machines working in parallel to perform the step 226 on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. In practice, moreover, different layers require different etch processes, for example chemical etches, plasma etches, according to the details of the material to be etched, and special requirements such as, for example, anisotropic etching.

The previous and/or subsequent processes may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore, some layers may be exposed in an immersion type lithography tool, while others are exposed in a 'dry' tool. Some layers may be exposed in a tool working at DUV wavelengths, while others are exposed using EUV wavelength radiation.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly, a manufacturing facility in which litho cell LC is located also includes metrology system which receives some or all of the substrates W that have been processed in the litho cell. Metrology results are provided directly or indirectly to the supervisory control system SCS. If errors are detected, adjustments may be made to exposures of subsequent substrates, especially if the metrology can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Also shown in Figure 1 is a metrology apparatus 240 which is provided for making measurements of parameters of the products at desired stages in the manufacturing process. A common example of a metrology station in a modern lithographic production facility is a scatterometer, for example a dark-field scatterometer, an angle-resolved scatterometer or a spectroscopic scatterometer, and it may be applied to measure properties of the developed substrates at 220 prior to etching in the apparatus 222. Using metrology apparatus 240, it may be determined, for example, that important performance parameters such as overlay or critical dimension (CD) do not meet specified accuracy requirements in the developed resist. Prior to the etching step, the opportunity exists to strip the developed resist and reprocess the substrates 220 through the litho cluster. The metrology results 242 from the apparatus 240 can be used to maintain accurate performance of the patterning operations in the litho cluster, by supervisory control system SCS and/or control unit LACU 206 making small adjustments over time, thereby minimizing the risk of products being made out-of-specification, and requiring re-work.

Additionally, metrology apparatus 240 and/or other metrology apparatuses (not shown) can be applied to measure properties of the processed substrates 232, 234, and incoming substrates 230. The metrology apparatus can be used on the processed substrate to determine important parameters such as overlay or CD.

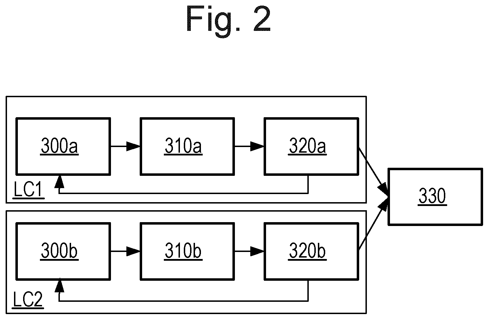

Figure 2 schematically depicts a device manufacturing arrangement/method for making bonded substrates (and therefore ICs based on bonded substrates) comprising a first manufacturing lithocell LC1 and a second manufacturing lithocell LC2. Within each lithocell is a lithographic processing system 300a, 300b and a first metrology system 3 10a, 3 10b. The lithographic processing system 300a, 300b, may comprise a full patterning system. Such a system may comprise, for example, an optical lithographic apparatus or scanner such as described in respect of Figure 1, a track tool, a deposition tool, an etch tool, any other apparatus used in the patterning process, or any combination selected therefrom. The systems may also each comprise a software application 320a, 320b in communication with its respective lithographic processing system 300a, 300b and metrology system 310a, 310b, so that results, designs, data, etc. of the lithographic processing system 300a, 300b and/or the metrology apparatus 310a, 310b may be stored and analyzed by the software application 320a, 320b at the same time or different times.

Once pairs of substrates (e.g. wafers) are completed from each of lithocell LC1 and lithocell LC2, they may be bonded within a bonding tool 330 to obtain a bonded wafer. A pair of substrates from a single lithocell (e.g. lithocell LC1) may also be bonded together. Bonding in this context may be wafer-to-wafer bonding where whole wafers are aligned and bonded together such that individual dies on each wafer are aligned. The concept of wafer-to-wafer bonding is known and used in many IC manufacturing processes. Bonding in this context may also be wafer-to-die or die-to-wafer bonding, in which an individual die is bonded to a wafer. Bonding in this context may also be die-to-die bonding, in which one individual die is bonded to another individual die. As used herein, the term "bonding method" is used to mean methods of bonding of one semiconductor substrate to another semiconductor substrate. The term "bonding method" is used to cover the bonding of one wafer to another wafer, of one die to a wafer, and of one die to another die. Further, as used herein (unless otherwise specified), the term "substrate" means "semiconductor substrate", which covers both wafers and dies.

The bonding tool 330 may comprise a bonding alignment device for aligning the substrates together for bonding. For example, the bonding tool 330 may perform pre-align using box-in-box marks provided to substrates (e.g., one box on each substrate), with visual inspection of marks used for alignment quality/ position control. Another method uses two imaging sensors (e.g., face to face) which are first calibrated together to find their relative positions; each sensor is then used to separately align a respective substrate to be bonded.

Lithocell LC1 and lithocell LC2 may be the same lithocell, different lithocells but comprising one or more shared tools and elements, or be completely different lithocells having completely different sets of apparatuses and tools, possibly even at different sites or fabs. For example, one or more of the tools or apparatuses of the lithographic processing systems 300a and 300b may comprise different tools or the same tools within each respective system. Similarly, metrology apparatuses 310 and 310b may be the same apparatus or different apparatuses. The software application 320a, 320b may be comprised within one or both of the respective lithographic processing systems 300a, 300b and/or one or both of the first metrology systems 310a, 310b, or elsewhere.

Once bonded, the bonded substrate may be subject to further lithographic patterning and processing. As such, alignment will be performed on the bonded substrate; e.g., for aligning the substrate and determining feed-forward corrections based on measured grid deformities. Also, post-exposure metrology, such as overlay metrology, may be performed on the bonded substrate after exposure; e.g., to determine feedback corrections for subsequent substrates.

At present, various bonding techniques have been implemented to bond semiconductor substrates (e.g. wafers). Among existing bonding techniques, fusion bonding and hybrid bonding are widely employed for bonding semiconductor substrates. Fusion bonding enables permanent connection via dielectric layers on each bonding semiconductor substrate and provides a good bonding strength with a high bonding yield. The dielectric layers may comprise, for example, silicon oxide, e.g. activated silicon oxide of the form SiOxHy. Additionally or alternatively, the dielectric layers may comprise, for example, SiON, e.g. activated SiON of the form SiOxNyHz. The activation of the silicon oxide or the SiON may comprise plasma activation or activation comprising use of a hydrogen radical generator.

Typically, the fusion bonding process comprises three main steps: 1) surface preparation which may include surface planarization, cleaning and activation; 2) pre-bonding at room temperature which may include aligning the two bonding surfaces; and 3) annealing (or heat treatment) at elevated temperatures (e.g., 200°C to 500°C). In the fusion bonding process, spontaneous adhesion of the two bonding surfaces occurs at room temperature via Van der Waals forces between the two bonding surfaces and via hydrogen bridge bonds of chemisorbed water molecules. The hydrogen bridge bonds of chemisorbed water molecules may react during the annealing step to form covalent siloxane bonds. The spontaneous adhesion of the two bonding surfaces (e.g. through Van der Waals forces and the like) may be referred to as optical bonding. Further information about the fusion bonding technique can be found in the book "Handbook of Wafer Bonding" edited by Peter Ramm, James J.-Q. Lu, and Maaike M. V. Taklo, published by Wiley-VCH, 11 January 2012, ISBN 9783527326464, which is incorporated herein by reference.

Hybrid bonding combines fusion bonding and metal diffusion bonding into a single bonding process and enables simultaneous formation of dielectric-to-dielectric and metal-to-metal bonds between the bonding surfaces of the two substrates. The metal-to-metal bonds between the two substrates may provide one or both of (a) increased bond strength between the two substrates; and (b) electrical connection between the two substrates (e.g. electrical connection between a functional device formed on one substrate and another functional device formed on another substrate).

In a hybrid bonding process, metal is embedded in bonding surfaces of the substrates that are to be bonded together. The metal may be copper, gold, or any other metal or metal alloy with a coefficient of thermal expansion that is greater than the coefficient of thermal expansion of the material from which the dielectric layer is formed. The metal may be embedded in the dielectric layer of the substrates that are to be bonded together. The metal embedded in the substrates may be in the form of a plurality of metallic portions (which may be referred to as metallic pads) distributed across the substrates (e.g. distributed across the dielectric layer of the substrates). The metallic portions may be formed in a surface preparation step of the hybrid bonding method. For example, the metallic pads may be formed by etching the dielectric layer on the substrate (e.g., to create vias to the metal below) and electroplating (or electrochemical deposition (ECD) of) at least part of the etched dielectric layer to form metal pads therewithin. The bonding surface of a substrate may also be referred to as a joining surface of the substrate.

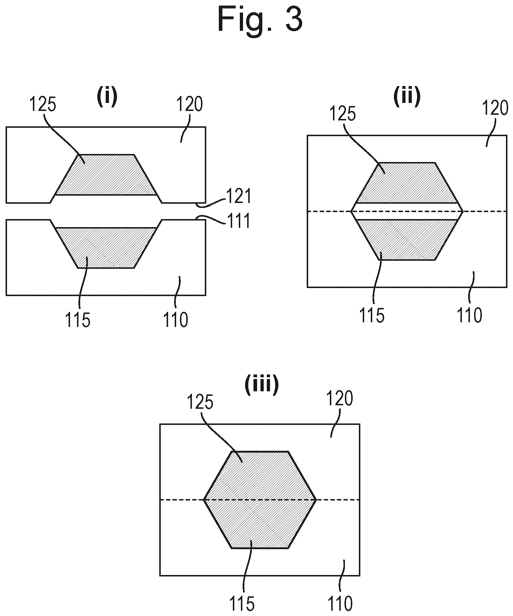

Similarly to the fusion bonding process, the hybrid bonding process also comprises the following three main steps: 1) surface preparation (in which the metallic portions may be formed, as described above); 2) pre-bonding at room temperature; and 3) annealing (or heat treatment) at elevated temperatures. Steps (2) and (3) are schematically depicted in Figure 3, which depicts a metallic portion 115 in a first substrate 110 and a metallic portion 125 in a second substrate 120. The single metallic portion on each of the first and second substrate 110, 120 is shown to explain the hybrid bonding process, and is representative of a plurality of metallic portions 115, 125.

At stage (i) in Figure 3, a bonding surface 111 of the first substrate 110 is separated (e.g. spaced apart from) from a bonding surface 121 of the second substrate 120. The bonding surface 111 of the first substrate 110 may be formed at least partially by a dielectric layer (not shown). The metallic portion 115 may be recessed below the bonding surface 121, but exposed at the bonding surface 121 (e.g. not covered by the dielectric layer). The bonding surface 121 of the second substrate 120 may be formed at least partially by a dielectric layer (not shown). The metallic portion 125 may be recessed below the bonding surface 121, but exposed at the bonding surface 121 (e.g. not covered by the dielectric layer).

In the hybrid bonding process, the two substrates 110, 120 may be aligned with one another. Then, the two substrates 110, 120 may be brought together such that the bonding surfaces 111, 121 come into contact, and are spontaneously bonded together (e.g. by optical bonding). At stage (ii) in Figure 3) the two substrates 110, 120 have been brought into contact with one another. At this point in the process, the metallic portion 115 of the first substrate 110 may not be bonded with (or in contact with) the metallic portion 125 of the second substrate 120. This may be because the metallic portions 115, 125 are recessed below the respective bonding surfaces 111, 121, as described above. By recessing the metallic portions 115, 125 below the respective bonding surfaces 111, 121, the metallic portions 115, 125 do not interfere with the initial optical bonding that occurs between the (dielectric) bonding surfaces 111, 121.

At stage (iii) in Figure 3, the two substrates 110, 120 have been subjected to an annealing (or heat treatment) step. As described above, the annealing (or heat treatment) transfers hydrogen bridge bonds to covalent siloxane bonds. Further, the heating of the metallic portions 115, 125 causes the metallic portions 115, 125 to expand up to or beyond the level of the respective bonding surfaces 111, 121. Thus, the metallic portions 115, 125 come into contact with one another. Where the metallic portions 115, 125 come into contact with one another, metal diffusion bonds may be formed. Further information about the hybrid bonding technique can be found in the book "Handbook of Wafer Bonding" edited by Peter Ramm, James J.-Q. Lu, and Maaike M. V. Taklo, published by Wiley-VCH, 11 January 2012, ISBN 9783527326464, which is incorporated herein by reference.

In many fusion or hybrid bonding applications, intermediate layers (e.g., silicon dioxide (SiO2), silicon carbon nitride (SiCN), silicon oxynitride (SiON)) are used to enhance bonding strength.

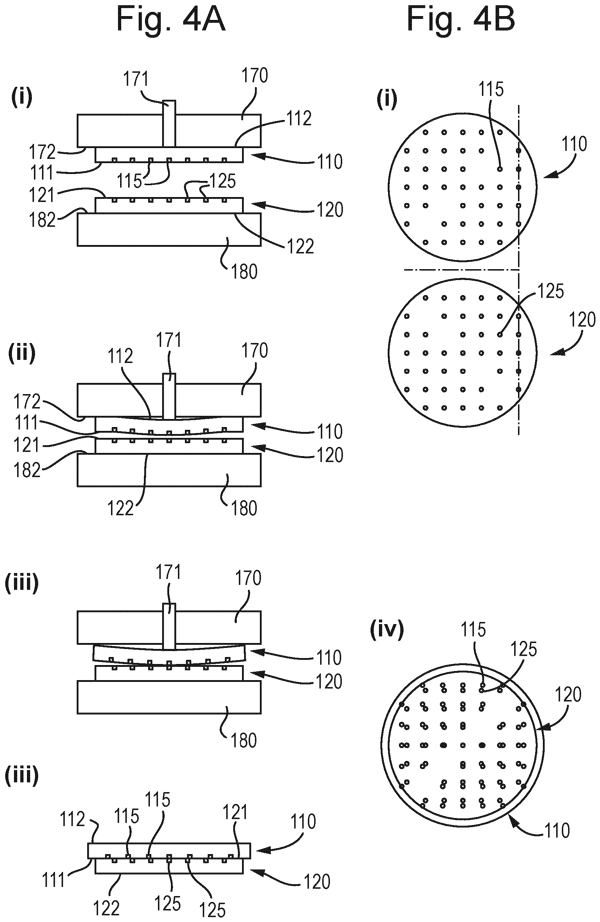

A conventional bonding method will now be described with reference to Figures 4A and 4B. The bonding method depicted in Figures 4A is a method for bonding a first semiconductor substrate 110 and a second semiconductor substrate 120. The first semiconductor substrate 110 comprises a bonding surface 111 and a plurality of metallic portions 115 distributed across the bonding surface 111. The second semiconductor substrate 120 also comprises a bonding surface 121 and a plurality of metallic portions 125 distributed across the bonding surface 121. This has been described in detail above.

In step (i) depicted in Figures 4A the first semiconductor substrate 110 is clamped to a first clamp 170. Specifically, a back surface 112 of the first semiconductor substrate 110 is in contact with a clamping surface 172 of the first clamp 170. As used in the present disclosure, the "back surface" of a substrate is a surface which is opposite to the bonding surface.

The clamping surface 172 of the first clamp 170 may comprise a plurality of support protrusions ("burls", not shown in the Figures). The back surface 112 of the first semiconductor substrate 110 may be supported on distal ends of the plurality of support protrusions. The first clamp 170 may be an electrostatic clamp comprising one or more electrodes (not shown) configured to apply an electrostatic clamping force to the first semiconductor substrate 110 to clamp the first semiconductor substrate 110 to the first clamp 170.

The second semiconductor substrate 120 may be clamped to a second clamp 180 in substantially the same way as the first substrate 110 is clamped to the first clamp 170. The first clamp 170 and the second clamp 180 may be arranged such that the bonding surfaces 111, 121 of the first and second substrates 110, 120 face one another.

As shown in Figure 4B, during step (i) (i.e. before the first substrate 110 is brought into contact with the second substrate 120), the metallic portions 115 on the first substrate 110 are substantially aligned with the metallic portions 125 portions on the second substrate 120.

The first clamp 170 may comprise a pushing means configured to push the first substrate 110 towards the second substrate 120. As shown in Figures 4A, the pushing means may comprise a pin 171. The pin 171 extends through a body of the first clamp 170. The pin 171 is extensible and retractable, so that the pin 171 can push the first substrate 110 towards the second substrate 120. The pin 171 may be configured to initiate contact between the first substrate 110 and the second substrate 120. Thus, the pin 171 may be configured to initiate spontaneous bonding between the first substrate 110 and the second substrate 120.

The pin 171 is located in a central (e.g. radially central) portion of the first clamp 170, such that the pin 171 pushes against a central (e.g. radially central) portion of the back surface 112 of the first substrate 110. As will be appreciated, the pushing means of the first clamp 170 may comprise a plurality of pins 171. The plurality of pins may all be centrally arranged, e.g. so as to exert a pushing force on the central (e.g. radially central) portion of the back surface 112 of the first substrate 110. In the example depicted in Figures 4A, the second clamp 180 does not comprise a pushing means.

In steps (ii) and (iii), the first substrate 110 is brought into contact with the second substrate 120. To bring the first substrate into contact which the second substrate 120, the clamping force (e.g. electrostatic clamping force) exerted on the first substrate 110 by the first clamp 170 (e.g. by one or more electrodes in the first clamp 170) is released. Simultaneously, the pin 171 is extended so as to apply a pushing force to the back surface 112 of the first substrate 110.

As the pin 171 pushes against the central portion of the first substrate 110, the central portion of the first substrate 110 accelerates towards the second substrate 120. Thus, a central portion of the bonding surface 111 of the first substrate 110 comes into contact with the bonding surface 121 of the second substrate. As the central portion of the bonding surface 111 of the first substrate 110 comes into contact with the bonding surface 121 of the second substrate 120, spontaneous bonding (e.g. by Van der Waal's forces and the like) occurs therebetween. This spontaneous bonding causes the first substrate 110 to be pulled down onto the second substrate 120. This occurs first at the radially-central portion of the first substrate 110, and then propagates radially outwards. The radially outward propagation of the region at which the bonding surface 111 of the first substrate 110 is bonded to the bonding surface 121 of the second substrate 120 is referred to as a bond wave. As the first substrate 110 is pulled down onto the second substrate 120, air between the two substrates 110, 120 is displaced.

The bond wave experienced by the first substrate 110 means that the first substrate 110 undergoes curvature as the first substrate 110 is brought into contact with the second substrate 120. This curvature results in distortion/deformation of the first substrate 110. The distortion of the first substrate 110 caused by the curvature of the first substrate 110 may be an expansion (e.g. a stretch) in the radial direction.

At step (iv) in Figures 4A, the first substrate 110 and the second substrate 120 have been bonded together and removed from the first and second clamp 170, 180. As depicted in Figure 4B, at step (iv), the metallic portions 115 of the first substrate are not aligned with the metallic portions of 125 of the second substrate 120. Specifically, the metallic portions 115 of the first substrate 110 are displaced radially outwards compared to the metallic portions 125 of the second substrate 120. The misalignment between the metallic portions 115 of the first substrate 110 and the metallic portions 125 and second substrate 120 increases as a function of radial distance from the centre of the first and second substrates 110, 120. The misalignment is a result of the radial expansion of the first substrate 110 during the pushing of the first substrate 110 towards the second substrate 120.

Once the first substrate 110 is fully in contact with second substrate 120 (and therefore the first substrate 110 is bonded to the second substrate 120), the first substrate 110 may not be able to contract (i.e. relax) back to its original dimensions. Thus, the first substrate 110 may remain in its radially-expanded form. Thus, the metallic portions of the first substrate 110 may remain misaligned relative to the metallic portions of the second substrate 120.

The present disclosure provides methods of bonding the first substrate 110 and the second substrate 120 with improved alignment between the two substrates 110, 120 (and, in particular, improved alignment between the metallic portions 115, 125 of the two substrates 110, 120). The bonding methods of the present disclosure may be similar to the conventional bonding method described above, except as described below.

In accordance with at least first and second embodiments of the present disclosure, alignment between the first substrate 110 and the second substrate 120 once bonded together is improved by applying the same operations to both the first substrate 110 and the second substrate 120. For example, the same (or substantially similar, or corresponding) pushing may be applied to both the first substrate 110 and the second substrate 120 during the bonding method. In this context, applying the same (or substantially similar, or corresponding) pushing to both the first substrate 110 and the second substrate 120 may mean that the first substrate 110 is pushed in a way that is substantially the same as the way in which the second substrate 120 is pushed.

Moreover, in at least the bonding methods according to the first and second embodiments, the first and second substrates 110, 120 may each undergo similar bonding processes, and therefore experience a similar bond wave phenomenon. By the first and second substrates 110, 120 experiencing the same (or similar) pushing, and/or by the first and second substrates 110, 120 experiencing a similar bond wave phenomenon, the first substrate 110 and the second substrate 120 each undergo the same or similar distortion/deformation (e.g. radial expansion). Consequently, the distortion of the first substrate 110 and the second substrate 120 during the bonding method does not result in misalignment of the metallic portions 115, 125 on the first and second substrates 110, 120. Thus, the alignment of the metallic portions 115, 125 on the first and second substrates 110, 120 can be improved.

In at least the bonding methods according to the first and second embodiments, the first substrate 110 may be pushed by a first pushing mechanism, and the second substrate 120 may be pushed by a second pushing mechanism. The first pushing mechanism may be the same as (or substantially similar to, or corresponding to) the second pushing mechanism. For example, the first pushing mechanism may be configured or arranged in the same way (or a substantially similar way) to the second pushing mechanism. In this way, during bonding method, the same (or substantially similar, or corresponding) pushing can be applied to both the first substrate 110 and the second substrate 120.

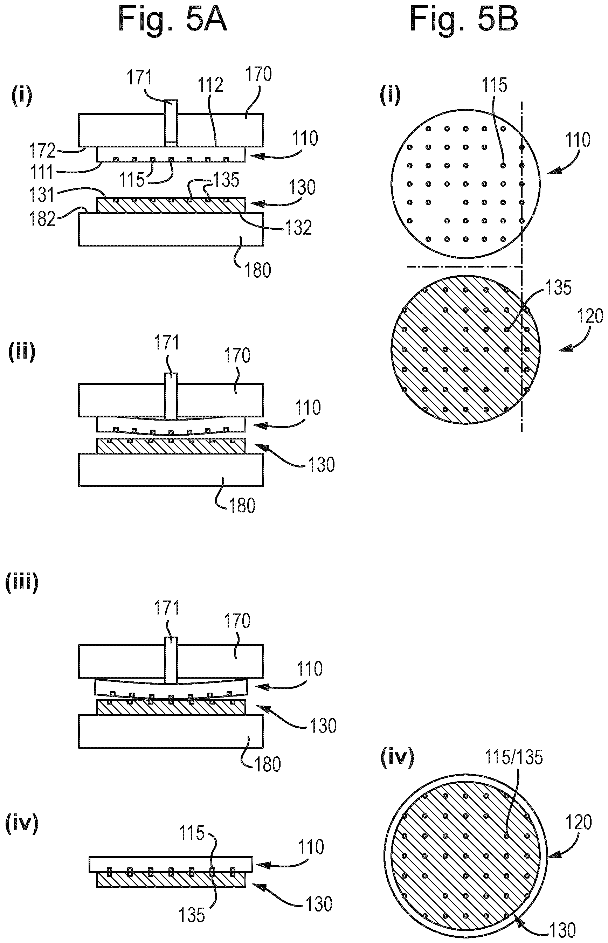

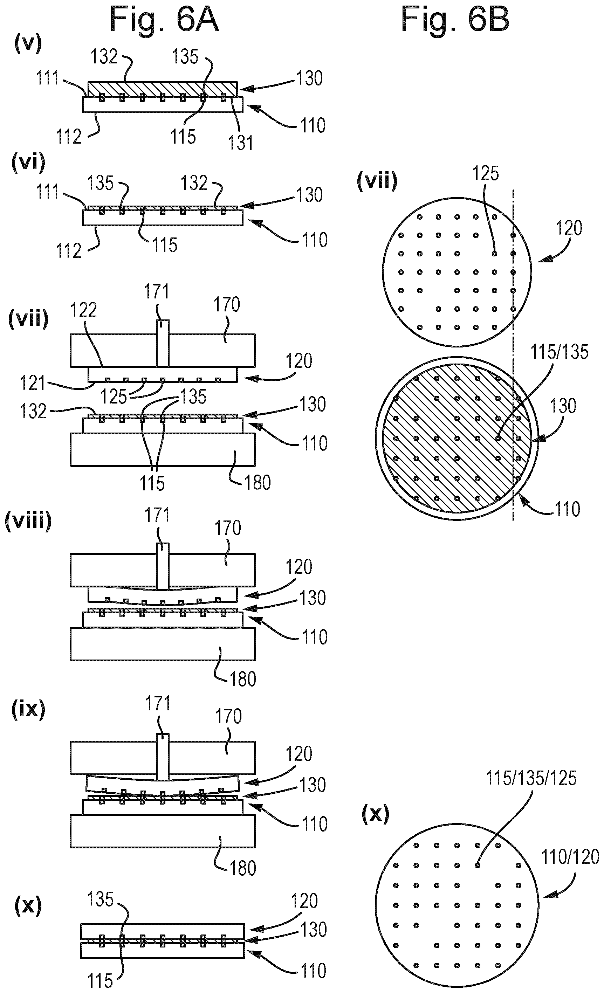

The bonding method according to the first embodiment of the present disclosure will now be described with referred to Figures 5A, 5B, 6A and 6B. In the bonding method according to the first embodiment, an auxiliary member 130 is utilised. The auxiliary member 130 remains between the first substrate 110 and the second substrate 120 in the finished bonded product. Consequently, the method of the first embodiment may be referred to as a method of joining the first substrate 110 and the second substrate 120, because the first substrate 110 is not directly bonded to the second substrate 120.

Figures 5A depicts a first portion of the method according to the first embodiment (steps (i) to (iv)), and Figure 6A depicts a second portion of the method according to the second embodiment (steps (v) to (x)). That is, the steps depicted in Figure 6A follow on from the steps depicted in Figure 5A. Figures 5B and 6B depict the alignment of the metallic portions 115, 125 of the first and second substrates 110, 120 during various stages of the bonding method according to the first embodiment.

At step (i) in Figures 5A, the first substrate 110 is clamped to the first clamp 170. The clamping of the first substrate 110 to the first clamp 170 may be as described with reference to Figure 4A. At step (i) in Figures 5A, the auxiliary member 130 is clamped to the second clamp 180. The auxiliary member 130 may be a semiconductor substrate. The auxiliary member 130 comprises a bonding surface 131. A bonding surface 131 of the auxiliary member 130 may be formed from a dielectric layer. The auxiliary member 130 may further comprise a plurality of metallic portions 135. The plurality of metallic portions 135 of the auxiliary member 130 may be distributed across the bonding surface 131 of the auxiliary member 130. The plurality of metallic portions 135 of the auxiliary member may be exposed at the bonding surface 131 of the auxiliary member 130. The second clamp 180 may support a back surface 132 of the auxiliary member 130 (where the back surface 132 of the auxiliary member is a surface opposite the bonding surface 131).

As shown in Figures 5B, at step (i), the metallic portions 115 of the first substrate 110 are not aligned with the metallic portions 135 of the auxiliary member 130. In other words, before the first substrate 110 is brought into contact with the auxiliary member 130, the metallic portions 115 of the first substrate 110 are not aligned with the metallic portions of the auxiliary member 130. Rather, the plurality of metallic portions 135 of the auxiliary member 130 are arranged so as to take into account the distortion/deformation (e.g. radial expansion) that the first substrate 110 will undergo during the pushing of the first substrate 110 of the auxiliary member 130. The distortion which the first substrate 110 will undergo during the pushing of the first substrate 110 onto the auxiliary member 130 may be known or predictable. The distortion which the first substrate 110 will undergo during the pushing of the first substrate 110 onto the auxiliary member 130 may be known from simulation or experimentation.

At steps (ii) and (iii) depicted in Figures 5A, the first substrate 110 is pushed towards the auxiliary member 130 by the pushing means of the first clamp 170. Before or during the pushing of the first substrate 110 towards the auxiliary member 130, a clamping force exerted on the first substrate 110 by the first clamp 170 may be released. The pushing of the first substrate 110 towards the auxiliary member 130 may be referred to as a first pushing. As depicted in Figures 5A and 6A, the pushing means is a pin 171, which may be similar to (or the same as) the pin 171 described in relation to Figure 4A.

As the first substrate 110 is pushed onto the auxiliary member 130, spontaneous bonding (e.g. by Van der Waal's forces and the like) may occur between the bonding surfaces 111, 131 of the first substrate 110 and the auxiliary member 130, and the first substrate 110 may be pulled onto the auxiliary member 130. During the time in which the first substrate 110 is brought into contact with the auxiliary member 130, the first substrate may undergo distortion/deformation (e.g. radial expansion). The distortion/deformation may be a result of the pushing of the first substrate 110 and/or the bond wave phenomenon experienced by the first substrate 110 as the first substrate is pulled onto the auxiliary member 130.

At step (iv), the first substrate 110 and the auxiliary member 130 are fully bonded together (e.g. bonded together by Van der Waal's forces and the like). As can be seen in Figures 5A and 5B, as a result of the radial expansion of the first substrate 110 during the time in which the first substrate 110 is brought into contact with the auxiliary member 130, the metallic portions 115 of the first substrate 110 align with the metallic portions 135 of the auxiliary member 130.

The bonding method according to the first embodiment of the present disclosure continues in Figure 6A. Step (v) is substantially the same as step (iv). That is, steps (iv) and (v) are the same step.

At step (vi), which occurs after the first substrate 110 is bonded to the auxiliary member 130, a process is performed to remove material from the back surface 132 of the auxiliary member 130, thus decreasing the thickness of the auxiliary member 130. Material may be removed from the back surface 132 of the auxiliary member to the extent that the metallic portions 135 of the auxiliary member 130 become exposed at the back surface 132 of the auxiliary member 130.

At steps (vii)-(x), which are depicted in Figure 6A, the auxiliary member 130 (to which the first substrate 110 is bonded) is bonded to the second substrate 120. Specifically, the back surface 132 of the auxiliary member 130 (at which the metallic portions 135 are exposed) is bonded to the bonding surface 121 of the second substrate 120.

At step (vii), the second substrate 120 is clamped to the first clamp 170. The back surface 132 of the second substrate 120 is supported by the first clamp 170. The first substrate 110 is clamped to the second clamp 180. This is such that the back surface 132 of the auxiliary member (at which the metallic portions 135 of the auxiliary member 130 are exposed) faces the bonding surface 121 of the second substrate 120.

Figure 6B shows the alignment between the metallic portions 125 of the second substrate 120 and the metallic portions 135 of the auxiliary member 130 at step (vii), i.e. before the second substrate 120 is brought into contact with the auxiliary member 130. As shown, before the second substrate 120 is brought into contact with the auxiliary member 130, the metallic portions 125 of the second substrate 120 are not aligned with the metallic portions 135 of the auxiliary member 130.

At steps (viii) and (ix), the second substrate 120 is brought into contact with the auxiliary member 130. The bringing of the second substrate 120 into contact with the auxiliary member 130 comprises pushing of the second substrate 120 towards the auxiliary member 130 by the pushing means of the first clamp 170. Before or during the pushing of the second substrate 120 towards the auxiliary member, a clamping force exerted on the second substrate 120 by the first clamp 170 may be released. The pushing of the second substrate 120 towards the auxiliary member 130 may be referred to as a second pushing.

As the second substrate 120 is pushed onto the auxiliary member 130, spontaneous bonding (e.g. by Van der Waal's forces and the like) may occur between the bonding surface 121 of the second substrate and the back surface 132 of the auxiliary member 130, and the second substrate 120 may be pulled onto the back surface 132 of the auxiliary member 130. During the time in which the second substrate 120 is brought into contact with the auxiliary member 130, the second substrate 120 may undergo distortion/deformation (e.g. radial expansion). The distortion/deformation of the second substrate 120 may be a result of the pushing of the second substrate and/or the bond wave phenomenon experienced by the second substrate 120 as the second substrate 120 is pulled onto the auxiliary member 130.

As the second substrate 120 is pushed towards the auxiliary member 130, the radial expansion of the second substrate 120 is such that the metallic portions 125 of the second substrate come into alignment with the metallic portions 135 of the auxiliary member 130. This alignment can be seen at step (x), at which the first substrate 110 fully joined to the second substrate 120 with the auxiliary member therebetween.

As will be recognised, the pushing of the first substrate 110 towards the auxiliary member 130 (i.e. steps (ii) and (iii) depicted in Figure 5A) may be substantially the same pushing as the pushing of the second substrate 120 towards the auxiliary member 130 (i.e. steps (viii) and (ix) depicted in Figure 6A). Consequently, the distortion/deformation (e.g. radial expansion) undergone by the first substrate 110 may be the same as (or substantially the same as) the distortion/deformation (e.g. radial expansion) undergone by the second substrate 120. Consequently, the metallic portions 115 of the first substrate 110 are aligned with the metallic portions 125 of the second substrate 120. In the bonding method according to the first embodiment of the present disclosure, the provision of the auxiliary member 130 allows both of the semiconductor substrates 110, 120 to be pushed in substantially the same way.

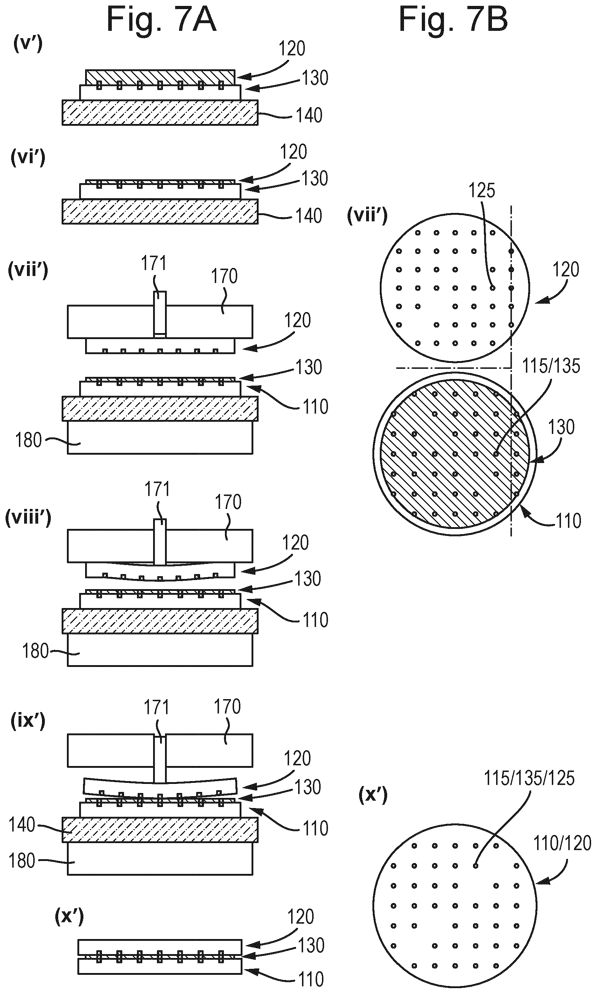

A modified version of the method according to the first embodiment will now be described with reference to Figure 7A. Figure 7A depicts steps (v') to (x') of the bonding method (i.e. the second portion of the bonding method which is depicted in Figure 6A). Unless otherwise specified, the steps (v')-(x') depicted in Figure 7A are the same as the steps (v)-(x) depicted in Figure 6A. In Figure 6A and 7A, corresponding reference numerals indicate corresponding steps. The steps (v')-(x') depicted in Figure 7A differ from steps (v)-(x) depicted in Figure 6A by the fact that a bracing member 140 is used. This will be described in further detail below.

Where a bracing member 140 is not used (e.g. as shown in Figure 6A) there is a risk that, as the thickness of the auxiliary member 130 is reduced by removing material from the back surface 132 of the auxiliary member 130 (step (vi) in Figure 6A), the bonded first substrate 110 and auxiliary member 130 may contract (e.g. relax radially inward). This is not desirable, because the method according to the first embodiment provides good alignment of the first substrate 110 and the second substrate 120 by matching the distortion/deformation of the first substrate 110 with that of the second substrate 120. Thus, if the first substrate 110 is allowed to contract, the first substrate 110 will not be aligned with the radially-expanded second substrate 120.

To prevent contraction of the first substrate 110 (and the auxiliary member 130 bonded thereto), a bracing member 140 may be affixed to the back surface 112 of the first substrate 110 (step (v') in Figure 7A). The bracing member 140 may be affixed to the back surface 112 before material is removed from the back surface 132 of the auxiliary member 130. The structure and material of the bracing member 140 are not particularly limited.

During the bringing of the second substrate 120 into contact with the auxiliary member 130 (steps (vii')-(ix') in Figure 7A), the bracing member 140 may be clamped to the second clamp 180. This may be such that the bracing member 140 is interposed between the second clamp 180 and the first substrate 110.

In the modified version of the bonding method according to the first embodiment, there may be a final step of removing the auxiliary member 140 from the back surface 112 of the first substrate 110.

After the steps depicted in Figures 6A or 7A (i.e. after step (x) or step (x')), the first substrate 110, the auxiliary member 130 and the second substrate 120 may be heated. The heating of the first substrate 110, the auxiliary member 130 and the second substrate 120 may bring the plurality of metallic portions 115 of the first substrate 110 into electrical contact with the plurality of metallic portions 135 of the auxiliary member 130, and therefore initiate metallic bonding therebetween. The heating of the first substrate 110, the auxiliary member 130 and the second substrate 120 may also bring the plurality of metallic portions 125 of the second substrate 120 into contact with the plurality of metallic portions 135 of the auxiliary member 130. and therefore initiate metallic bonding therebetween. Thus, the heating of the first substrate 110, the auxiliary member 130 and the second substrate 120 may be such that the plurality of metallic portions 115 of the first substrate 110 are brought into electrical contact with the plurality of metallic portions 125 of the second substrate 120 (via the plurality of metallic portions 135 of the auxiliary member 130).

In another modified version of the bonding method according to the first embodiment, the auxiliary member 130 may comprise metallic vias (not shown) formed between the bonding surface 131 of the auxiliary member 130 and the back surface 132 of the auxiliary member 130. The metallic vias may be instead of the metallic portions 130 of the auxiliary member 130. The metallic vias may be exposed at the bonding surface 131 of the auxiliary member 130 and at the back surface 132 of the auxiliary member. Thus, the material removal steps (e.g. step (vi) depicted in Figure 6A) may not be necessary.

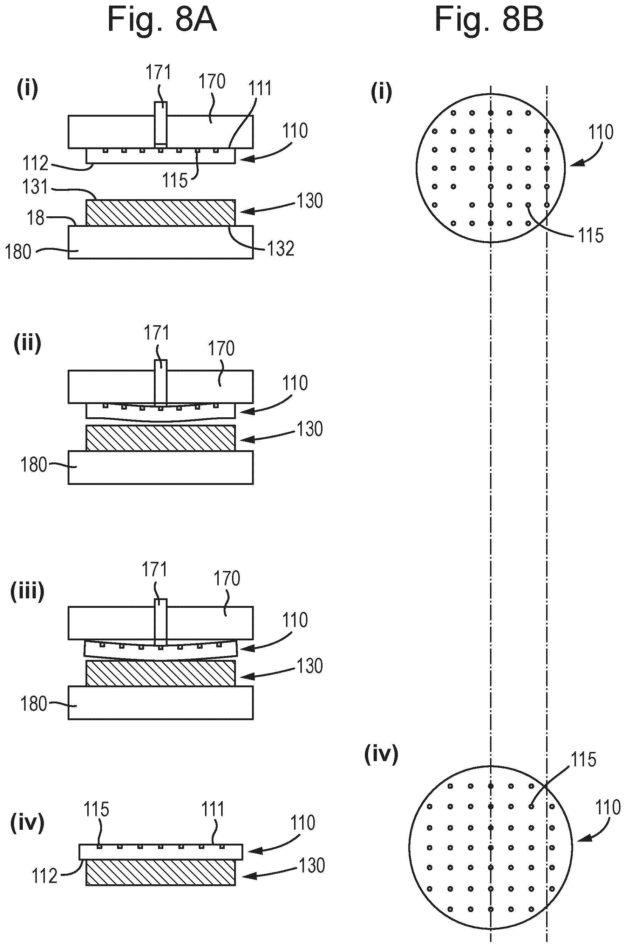

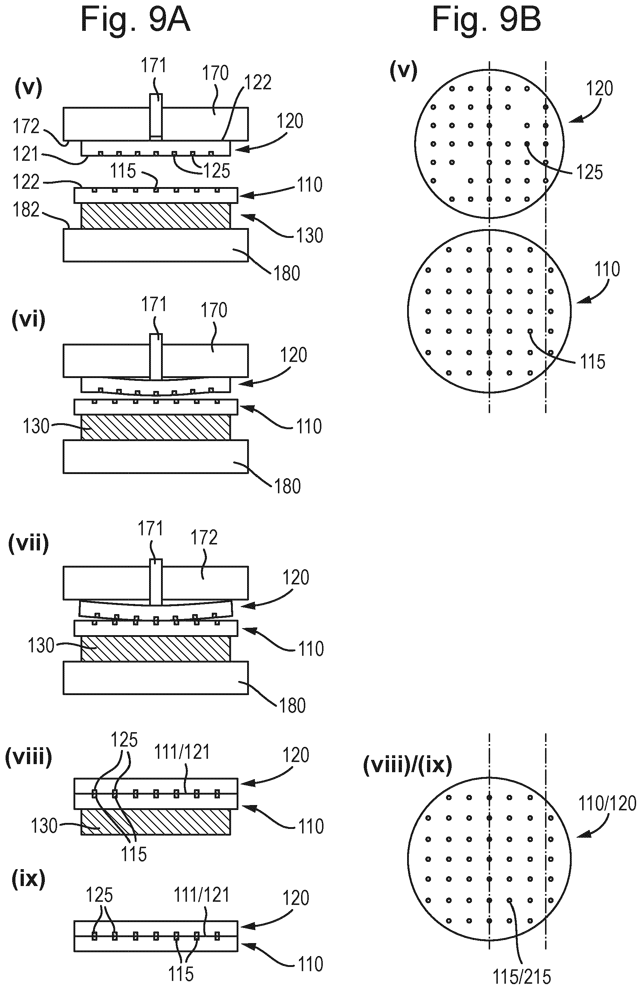

A bonding method according to the second embodiment of the present disclosure will now be described with reference to Figure 8A, 8B, 9A and 9B. As with the bonding method according to the first embodiment, in the bonding method according to the second embodiment the pushing that is performed on the first substrate 110 is substantially the same as the pushing that is performed on the second substrate 120. In this way, metallic portions 115 of the first substrate 110 are substantially aligned with metallic portions 125 the second substrate 120 once the first substrate 110 is bonded to the second substrate 120. The bonding method according to the second embodiment also makes use of an auxiliary member 130. However, in the bonding method according to the second embodiment, the first substrate 110 is directly bonded to the second substrate 120 (i.e. without the auxiliary member 130 in between). Further, the auxiliary member 130 does not form part of the final bonded product.

At step (i) in Figure 8A, the first substrate 110 is clamped to the first clamp 170. When the first substrate 110 is clamped to the first clamp 170, it is the bonding surface 111 of the first substrate 110 which is supported (e.g. in contact with) the clamping surface 172 of first clamp 170. An auxiliary member 130 is clamped to the second clamp 180.

In accordance with the second embodiment, the auxiliary member 130 need not comprise metallic portions. For the purposes of the bonding method according to the second embodiment of the present disclosure, the auxiliary member 130 may be simply a silicon substrate, or a silicon substrate with a dielectric layer formed thereon.

A surface of the auxiliary member 130 that comes into contact with the back surface 112 of the first substrate 110 may be referred to as a bonding surface 131 of the auxiliary member 130. At least a portion (e.g. greater than 50% and preferably greater than 90%) of the bonding surface 131 of the auxiliary member 130 may have similar properties to the properties of the bonding surface 111 of the first substrate 110. Said properties may include surface energy and/or surface roughness. It may be preferable for the surface energy of the bonding surface 131 of the auxiliary member 130 to be within +/- 50% and preferably within +/- 10% of the surface energy of the bonding surface 111 of the first substrate 110. It may be preferable for the surface roughness of the bonding surface 131 of the auxiliary member 130 to be within +/- 50% and preferably within +/- 10% of the surface roughness of the bonding surface 111 of the first substrate. This may mean that the bonding which occurs between the first substrate 110 and the auxiliary member 130 is similar to the bonding which later occurs between the first substrate 110 and the second substrate 120. Thus, the distortion/deformation of the substrates 110, 120 in the two bonding steps may be substantially the same.

At steps (ii) and (iii) of Figure 8A, the first substrate 110 is brought into contact with auxiliary member 130. The bringing together of the first substrate 110 and the auxiliary member 130 causes the first substrate 110 to be bonded (e.g. by Van der Waal's forces and the like) to the auxiliary member 130. That is, the bringing together of the first substrate 110 and the auxiliary member 130 initiates bonding therebetween.

To bring the first substrate 110 into contact with the auxiliary member 130 (and therefore to initiate bonding between the first substrate 110 and the auxiliary member 130), the pushing means of the first clamp 170 may push against the bonding surface 111 of the first substrate 110. The pushing against the bonding surface 111 of the first substrate 110 in the bonding method according to the second embodiment may be referred to as a first pushing. In the example depicted in Figure 8A, the pushing means of the first clamp 170 is the pin 171. Before or during the pushing of the first substrate 110 towards the auxiliary member 130, a clamping force exerted on the first substrate 110 by the first clamp 170 may be released.

Pushing the bonding surface 111 of the first substrate 110 with the pin 171 causes the back surface 112 of the first substrate 110 to come into contact with the bonding surface 131 of the auxiliary member 130, and the back surface 112 of the first substrate becomes bonded (e.g. through Van der Waal's forces and the like) to the bonding surface 131 of the auxiliary member 130. The back surface 112 of the first substrate 110 is a surface opposite to the bonding surface 111 (e.g. the back surface 112 of the first substrate 110 is a surface opposite to the surface which is to be bonded to the second substrate 120). At step (iv) of Figure 8A, the first substrate 110 has been fully bonded to the auxiliary member 130.

During the bringing of the first substrate 110 into contact with the auxiliary member 130, spontaneous bonding (e.g. by Van der Waal's forces and the like) may occur therebetween, and the first substrate 110 may be pulled onto the bonding surface 131 of the auxiliary member 130. Thus, during the time in which the first substrate 110 is brought into contact with the auxiliary member 130, the first substrate 110 may undergo distortion/deformation (e.g. radial expansion) as a result of the pushing of the first substrate 110 and the bond wave phenomenon described above. Figure 8B shows that during the pushing of the first substrate 110 towards the auxiliary member 130, the first substrate 110 expands radially outward, and so the metallic portions 115 formed thereon are displaced radially outward.

The bonding method according to the second embodiment continues at Figure 9A. As depicted in step (v), after the first substrate 110 is bonded to the auxiliary member 130 (e.g. through Van der Waal's forces and the like), the auxiliary member 130 is clamped to the second clamp 180. In particular, the auxiliary member 130 is clamped to the second clamp 180 such that the surface of the auxiliary member 130 opposite to the bonding surface 131 of the auxiliary member 130 is supported by (and in contact with) the second clamp 180. The second substrate 120 is supported by the first clamp 170. In particular, the back surface 122 of the second substrate 120 is in contact with the second clamp 170. This is such that the bonding surface 121 of the second substrate 120 faces the bonding surface 111 of the first substrate 110.

At steps (vi) and (vii) depicted in Figure 9A the second substrate 120 is pushed towards the first substrate 110 by the pushing means of the first clamp 170. The pushing of the second substrate 120 towards the first substrate 110 may be referred to as a second pushing. Before or during the pushing of the second substrate 120 towards the first substrate 110, a clamping force exerted on the second substrate 120 by the first clamp 170 may be released. In the example shown in Figure 9A, the pushing means of the first clamp 170 is the pin 171, as has been described above. The pin 171 may push against the back surface 112 of the second substrate 120 to bring the bonding surface 121 of the second substrate 120 into contact with the bonding surface 111 of the first substrate 110.

Bringing the second substrate 120 into contact with the first substrate 110 may initiate spontaneous bonding (e.g. by Van der Waal's forces and the like) therebetween, and the second substrate 120 may be pulled onto the bonding surface 111 of the first substrate 110. Thus, during the time in which the second substrate 120 is brought into contact with the first substrate 110, the second substrate may undergo distortion/deformation (e.g. radial expansion) as a result of the pushing of the second substrate 120 and/or the bond wave phenomenon described above.

The radially-outward expansion of the second substrate 120 during the pushing of the second substrate 120 towards the first substrate 110 (e.g. steps (vi) and (vii) in Figure 9A) may be substantially the same as the radially-outward expansion of the first substrate 110 during the pushing of the first substrate 110 towards the auxiliary member (e.g. steps (ii) and (iii) in Figure 8A). Thus, once the first substrate 110 and the second substrate 120 are bonded together, the metallic portions 115 of the first substrate 110 may be aligned with the metallic portions 125 of second substrate 120. This is shown in steps (viii) and (ix) in Figure 9A and 9B. Consequently, in the bonding method according to the second embodiment, the alignment of the metallic portions 115 of the first substrate 110 with the metallic portions 125 of second substrate 120 may be improved relative to the conventional bonding method depicted in Figures 4A and 4B.

At step (ix) of the bonding method according to the second embodiment, the auxiliary member 130 may be removed from the back surface 112 of the first substrate 110. This may leave the first substrate 110 and the second substrate 120 bonded together, such that metallic bonding is initiated therebetween.

After the steps depicted in Figure 9A, the first substrate 110 and the second substrate 120 may be heated. The heating of the first substrate 110 and the second substrate 120 may bring the plurality of metallic portions 115 of the first substrate 110 into contact with the plurality of metallic portions 125 of the second substrate 120.

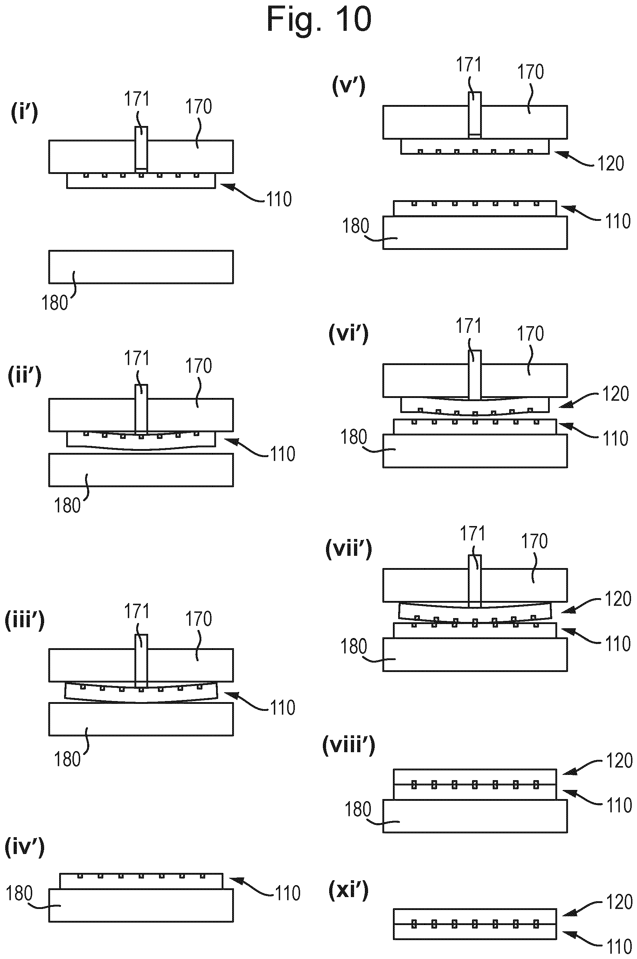

Figure 10 depicts a modified version of the bonding method according to the second embodiment. The bonding method depicted in Figure 10 may be substantially the same as the bonding method depicted in Figures 7A and 8A, expect as described below. Corresponding references signs in Figures 7A, 8A and 10 indicated corresponding steps of the bonding methods.

In the bonding method depicted in Figure 10, the back surface 112 of the first substrate 110 is initially brought into contact with the second clamp 180 by pushing the first substrate 110 with the pushing means of the first clamp 170. This is depicted in steps (i') to (iii') of Figure 10. Steps (i') to (iii') in Figure 10 may correspond to steps (i) to (iii) in Figure 7A. That is, in the modified version of the bonding method according to the second embodiment, the back surface 110 is initially laid onto the second clamp 180, rather than initially bonding the back surface 112 of the first substrate 110 to an auxiliary member 130. In the modified version of the bonding method according to the second embodiment, the second clamp 180 may perform the function of the auxiliary member 130. Thus, in the modified version of the bonding method according to the second embodiment, the second clamp 180 may be considered to be an auxiliary member.

The laying down of the first substrate 110 to the second clamp 180 may comprise pushing the bonding surface 111 of the first substrate 110 using the pin 171 of the first clamp. Thus, as the first substrate 110 is laid down onto the second clamp 180, the first substrate 110 may undergo distortion/deformation (e.g. radial expansion). Once laid on the second clamp 180 (as shown in step (iv') of Figure 10), a frictional force between the plurality of support protrusions (i.e. burls) on the second clamp 180 and the back surface 112 of the first substrate 110 may be sufficient to prevent the first substrate 110 from contracting radially inward. The remainder of the method depicted in Figure 10 may proceed as described with reference to Figure 7A and 8A, expect for the fact that the back surface 112 of the first substrate 110 is supported directly by the second clamp 180 (rather than the back surface 112 of the first substrate 110 being bonded to the auxiliary member 130, which is supported by the second clamp 180).

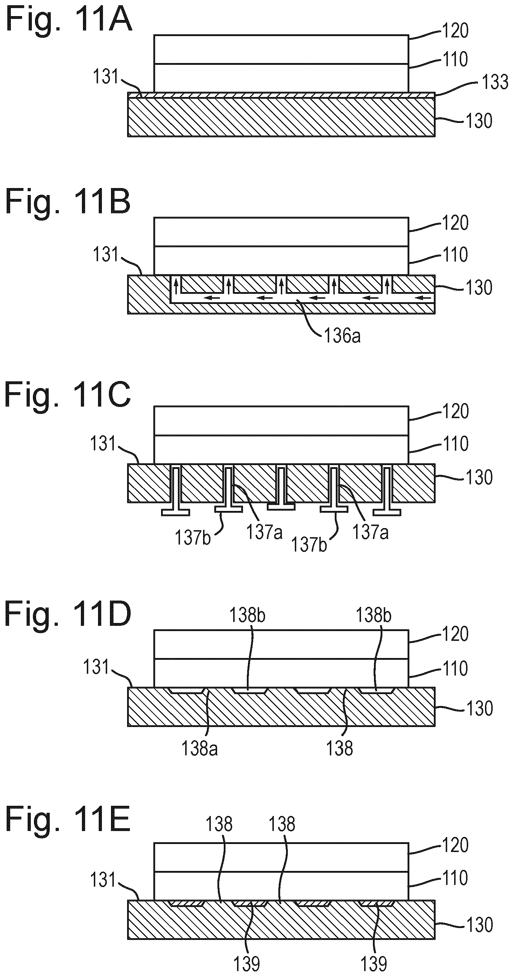

In the bonding method according to the second embodiment (as depicted in Figure 7A and 8A), the first substrate 110 is temporarily bonded to an auxiliary member 130. Figure 11A depicts an auxiliary member 130 with a coating 133 formed thereon. The coating 133 of the auxiliary member 130 may form the bonding surface 131 of the auxiliary member 130. The coating 133 on the auxiliary member may have properties similar to those of the first substrate 110 and the second substrate 120. Thus, the provision of the coating 133 on the auxiliary member may allow the bonding between the first substrate 110 and the auxiliary member 130 (e.g. as shown in steps (i) to (iv) in Figure 8A) to mimic the bonding between the second substrate 120 and the first substrate 110 (e.g. as shown in steps (vi) to (viii) in Figure 9A). This may increase the extent to which the distortion/deformation experienced by the first substrate 110 matches (e.g. is the same as) the distortion/deformation experienced by the second substrate 120. Thus, the provision of the coating 133 on the auxiliary member in the bonding method according to the second embodiment may further improve the alignment of the metallic portions 115, 125 in the first and second substrates 110, 120.

At the end of the method according to the second embodiment (as depicted in Figure 7A and 8A), the auxiliary member 130 may be removed from the first substrate 110. Figures 11B-11E depict various arrangements of auxiliary member 130 which allow for the simple/easy removal of the first substrate 110 from the auxiliary member 130.

Figure 11B depicts an auxiliary member 130 comprising a conduit 136. The conduit is configured to allow the passage of fluid from an inlet to a region between the auxiliary member 130 and the first substrate 110. The conduit 136 comprises one or more portions which extend up to the bonding surface 131 of the auxiliary member. In this way, by applying pressure to the back surface 112 of the first substrate 110 using fluid in the conduit 136, the first substrate 110 can be removed from the auxiliary member 130. The conduit may comprise a plurality of portions which extend up to the bonding surface 131 of the auxiliary member. The plurality of portions may be distributed across the bonding surface 131, such that a spatially uniform force can be applied to the back surface 112 of the first substrate 110.

Figure 11C depicts an auxiliary member 130 in which one or more channels 137a are formed. The one or more channels 137a may be formed through the auxiliary member 130 in a direction which is substantially perpendicular to the bonding surface 131 of the auxiliary member. The one or more channels 137a may be configured for the passage of one or more pins 137b therethrough. Thus, with the auxiliary member 130 depicted in Figure 11C, it may be possible to remove the first substrate 110 from the auxiliary member 130 by extending the one or more pins 137b through the one or more channels 137a. When the one or more pins are extended through the one or more channels 137a, distal ends of the one or more pins 137b may extend above the bonding surface 131 of the auxiliary member 130. Consequently, the distal ends of the one or more pins 137b may apply a force to the back surface 132 of the first substrate 130 to push the first substrate 110 away from the auxiliary member 130.

Figure 11D depicts an auxiliary member 130 in which the bonding surface comprises a plurality of support protrusions 138a thereon. The plurality of support protrusions 138a formed on the auxiliary member 130 may define the bonding surface 131 of the auxiliary member 130. The plurality of support protrusions 138a may be similar to the plurality of support protrusions which are provided on the clamping surfaces 171,181 of the first clamp 170 and the second clamp 180. The back surface 112 of the first substrate 110 may not contact auxiliary member 130 in regions 138b between the plurality of support protrusions 138a. Consequently, by providing the support protrusions 138a, a bonding force between the bonding surface 131 of the auxiliary member 130 and the back surface 112 of the first substrate 110 may be reduced (because the contacting surface area is reduced). Consequently, it may be easier to remove the first substrate 110 from the auxiliary member 130.

Figure 11E depicts an auxiliary member 130 comprising a plurality of expanding portions 139 disposed at the bonding surface 131 of the auxiliary member 130. In the example depicted in Figure 11E, the auxiliary member 130 may comprise a plurality of support protrusions 138 (as described in relation to Figure 11D), and the plurality of expanding portions 139 may be provided between the plurality of support protrusions 138A. The plurality of expanding portions 139 of the auxiliary member 130 depicted in Figure 11E may be configured in such that, upon heating the bonded first substrate 110 and auxiliary member 130, the expanding portions 139 expand. Expansion of the expanding portions 139 causes the expanding portions 139 to push the back surface 112 of the first substrate 110 away from the auxiliary member 130.

The plurality of expanding portions 139 may have a higher thermal expansion coefficient than a main body of the auxiliary member 130. While Figure 11E depicts a plurality of expanding portions 139, it will be recognised that there only needs to be one expanding portion 139 for the first substrate 110 to be separated from the auxiliary member 130 using this technique.

The heating of the bonded first substrate 110 and the auxiliary member 130 to cause expansion of the expanding portions 139 (and thus the separation of the first substrate 110 and the auxiliary member 130) may be the heating step which causes the metallic portions 115 of the first substrate 110 to come into contact with the metallic portions 125 of the second substrate 120. Alternatively, the heating of the bonded first substrate 110 and the auxiliary member 130 to cause expansion of the expanding portions 139 (and thus the separation of the first substrate 110 and the auxiliary member 130) may be a different heating step to the heating step which causes the metallic portions 115 of the first substrate 110 to come into contact with the metallic portions 125 of the second substrate 120. For example, the heating of the bonded first substrate 110 and the auxiliary member 130 to cause expansion of the expanding portions 139 (and thus the separation of the first substrate 110 and the auxiliary member 130) may be performed before the heating step which causes the metallic portions 115 of the first substrate 110 to come into contact with the metallic portions 125 of the second substrate 120, or after the heating step which causes the metallic portions 115 of the first substrate 110 to come into contact with the metallic portions 125 of the second substrate 120.

The techniques described for allowing simple/easy removal of the first substrate 110 from the auxiliary member 130 in the bonding method according to the second embodiment may be applied equally for allowing the simple/easy removal of the first substrate 110 from the bracing member 140 (e.g. the bracing member 140 which is used in the modified version of the bonding method according to the first embodiment). That is, the bracing member 140 may have any of the structural or functional features described in relation to the auxiliary member with reference to Figures 11B to 11D. Where the bracing member 140 comprises pins such as the pins 137b depicted in Figure 11C, the pins may be referred to as bracing pins.

In the bonding method according to the second embodiment, the first clamp 170 (e.g. the plurality of support protrusions at the clamping surface 172 of the first clamp 170) may come into contact with the bonding surface 111 of the first substrate 110. Further, in the bonding method according to the second embodiment, the pushing means 171 of the first clamp 170 (e.g. the pin 171) pushes against the bonding surface 111 of the first substrate 110. It is desirable that this clamping of, and pushing against, the bonding surface 111 of the first substrate 110 does not cause damage to the bonding surface 111. For example, it is desirable that the clamping of, and pushing against, the bonding surface 111 of the first substrate 110 does not cause damage to the metallic portions 115 which are exposed at the bonding surface 111 of the first substrate 110.

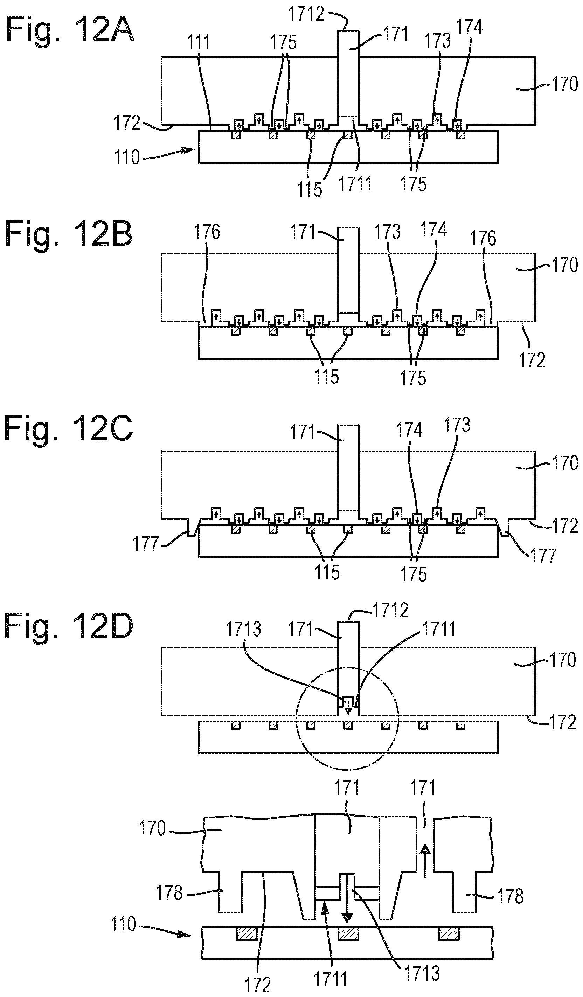

Figures 12A to Figures 12D depict variations of the first clamp 170. The variations of the first clamp 170 are adapted to reduce the risk of damage to the bonding surface 111 of the first substrate 110 during the time in which the first substrate is clamped to the first clamp and during the time in which the first substrate 110 is pushed towards the second substrate 120 by the pushing means of the first clamp 170.

Figure 12A depicts a first clamp 170 which is configured to minimise damage between support protrusions 175 of the first clamp and the bonding surface 111 of the first substrate 110. As depicted in Figure 12A, the first clamp 170 comprises distributed suction portions 173 and fluid supply portions 174. Flows of gas between the bonding surface 111 of the first substrate 110 and the clamping surface 172 of the first clamp 170 arise from the distributed flow supply and flow suction portions 173, 174 across the first clamp 170. The support protrusions 175 of the first clamp 170 are separated from the bonding surface 111 of the first substrate 110 by the flows of gas. Consequently, damage caused to the bonding surface 111 of the first substrate 110 by contact between the support protrusions 175 of the first clamp 170 and the bonding surface 111 of the first substrate 110 is avoided and/or reduced.

Figure 12B depicts a first clamp 170 with an edge protrusion 176. The edge protrusion of the first clamp 170 is configured to contact the bonding surface 111 of the first substrate 110 at a region which is radially outward of the plurality of metallic portions 115 on the bonding surface 111 of the first substrate 110. In this context, a region of the bonding surface 111 of the first substrate at which the plurality of metallic portions 115 are present may be referred to as a functional region. Thus, the contact between the edge portion 176 of the first clamp 170 and the bonding surface 111 of the first substrate 110 does not result in damage to the metallic portions 115 on the bonding surface 111 of the first substrate 110.

The height of the edge protrusion 176 may be greater than the height of the plurality of support protrusions 175. Thus, the plurality of support protrusions 175 may be separated from the bonding surface 111 of the first substrate 110. As shown in Figure 12B, the first clamp 170 comprises the distributed flow supply and flow suction portions described in relation to Figure 12A in addition to the edge protrusion 176. However, this is not essential, and the edge protrusion 176 may be provided in the absence of the distributed flow supply and flow suction portions 173, 174.

Figure 12C depicts a variant of the first clamp 170 depicted in Figure 12B. The first clamp 170 depicted in Figure 12C comprises an edge portion 177 which is similar to the edge portion 176 of the first clamp 170 depicted in Figure 12B. However, the edge portion 177 of the first clamp 170 depicted in Figure 12C is configured to support a circumferential edge of the first substrate 110. The edge portion 177 of the first clamp 170 depicted in Figure 12C may have an inclined surface for contacting the circumferential edge of the first substrate 110. The edge portion 177 may be configured to constrain the position of the first substrate 110 in the radial direction in the case where the first substrate is supported by the flows of gas provided by the distributed flow supply and flow suction portions 173, 174.

Figure 12D depicts a first clamp 170 with a pin 171 which is configured to push against the bonding surface 111 of the first substrate 110 without causing damage thereto. This is achieved by providing an air bearing-type arrangement at a distal end 1711 of the pin 171. The air bearing-type configuration is achieved by providing, at the distal end 1711 of the pin 171, an opening 1713 configured to allow a flow of fluid therethrough. Using the opening 1713 of the pin 171, fluid can be made to flow towards the bonding surface 171 of the first substrate 110. This may be such that, as the pin 171 is moved towards the bonding surface 111 of the first substrate 110 to initiate the pushing of the first substrate 110, the distal end 171 of the pin does not actually come into direct contact with the bonding surface 111 of the first substrate 110. Rather, a force is applied to the bonding surface 111 of the first substrate 110 by the pin 171 via the flow of air which is provided via the opening 1713.

A seal arrangement 178 may be provided around the pin 171 to prevent the fluid that is provided via the opening 1713 from propagating radially outward. This sealing arrangement 178 may comprise a wall which protrudes from the clamping surface 172 of the first clamp 170. Within the area bounded by the sealing arrangement 178, there may be an extraction opening 179 configured to remove fluid that has flowed through the opening 1713 in the distal end 1711 of the pin 171.

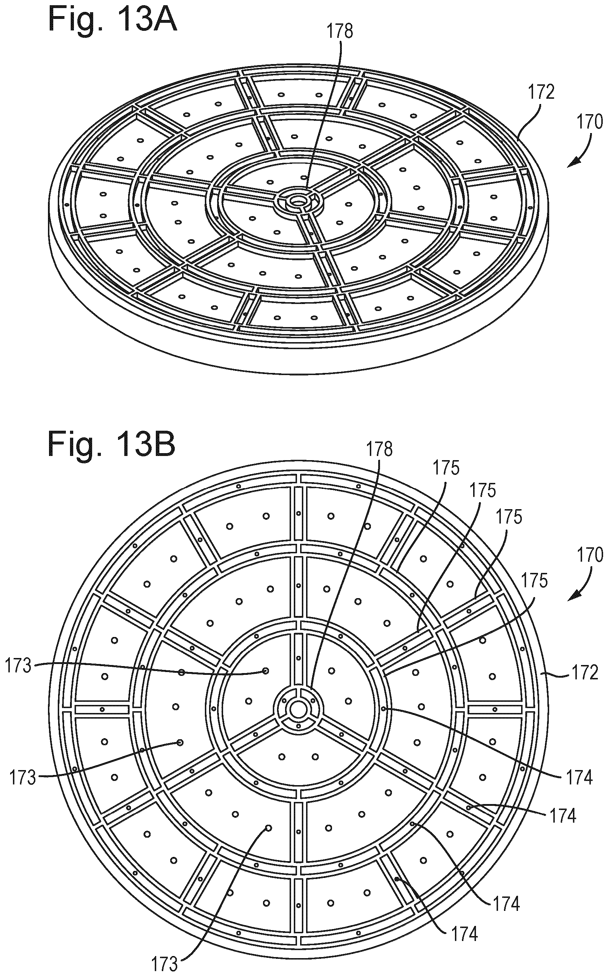

Figures 13A and 13B depict an isometric view and a plan view of a first clamp 170 which comprises some of the features described in relation to Figures 12A to 12D.

In the above description of the bonding methods according to the first and second embodiments, a first clamp 170 and a second clamp 180 have been referred to. The first clamp 170 and the second clamp 180 may collectively be referred to as a clamping apparatus. In the above description, it has been described that the same first clamp 170 and second clamp 180 may be used for different bonding steps. However, this is not essential. For example, the clamp apparatus used for one bonding step may be different to (i.e. independent of) the clamp apparatus used in another bonding step. That is, two or more clamp apparatuses may be used, with each clamp apparatus being used to perform a different step (or collection of steps) of the bonding method. Where two or more clamp apparatuses are used, the two or more clamp apparatuses may have the same, similar or corresponding features.

In the steps referred to as "first pushing" steps, the pushing may be performed by a first pushing mechanism, and in the steps referred to as "second pushing" steps, the pushing may be performed by a second pushing mechanism. The first pushing mechanism may have a configuration which is substantially the same as (or corresponds to) a second pushing mechanism. In some embodiments, both the first pushing mechanism and the second pushing mechanism may be a pushing means of a clamp. In some embodiments, the first pushing mechanism may comprise the first pushing means (e.g. the pin 171) of one first clamp 170 and the second pushing mechanism may comprise the first pushing means (e.g. the pin 171) of another (different) first clamp 170. Alternatively, the first pushing mechanism may comprise the first pushing means (e.g. the pin 171) of a first clamp 170 and the second pushing mechanism may comprise the same first pushing means (e.g. the same pin 171) of the same first clamp 170.

Referring specifically to the bonding method in accordance with the first embodiment (see Figures 5A and 6A), the first clamp 170 and the second clamp 180 used in the steps depicted in steps (i)-(iii) in Figures 5A may be the same as the first clamp 170 and the second clamp 180 used in the steps depicted in steps (vii)-(ix) in Figure 6A. In other words, in the bonding method according to the first embodiment, the clamp apparatus used to push the first substrate 110 towards the auxiliary member 130 may be the same as the clamp apparatus that is used to push the second substrate 120 onto the auxiliary member 130.

However, in some implementations of the bonding method according to the first embodiment, one clamp apparatus may be used to perform the steps (i)-(iii) in Figures 5A, and another clamp apparatus may be used to perform the steps (vii)-(ix) in Figure 6A . The two clamp apparatuses may be substantially the same, such that the pushing/bonding in steps (i)-(iii) is substantially the same as the pushing/bonding in steps (vii)-(ix). Alternatively, the two clamp apparatuses may be materially different, but configured to apply substantially the same pushing force. For example, the two clamp apparatuses may have the same or corresponding pushing means. For example, the two clamp apparatuses may each comprise a first clamp 170 having a single, centrally-located pin 171 as the pushing means. Alternatively, the two clamp apparatuses may each comprise a first clamp 170 comprising one or more pins as the pushing means, and one or more pins of each clamp apparatus may be correspondingly arranged.

In the bonding method according to the second embodiment (see Figures 8A and 9A), it has been described that the same clamp apparatus is used in the steps (i) to (iii) in Figures 8A as the clamp apparatus that is used in the steps depicted in steps (v) to (vii) in Figure 9A. However, this is not essential, and two or more clamp apparatuses may be used to perform different parts of the bonding method.

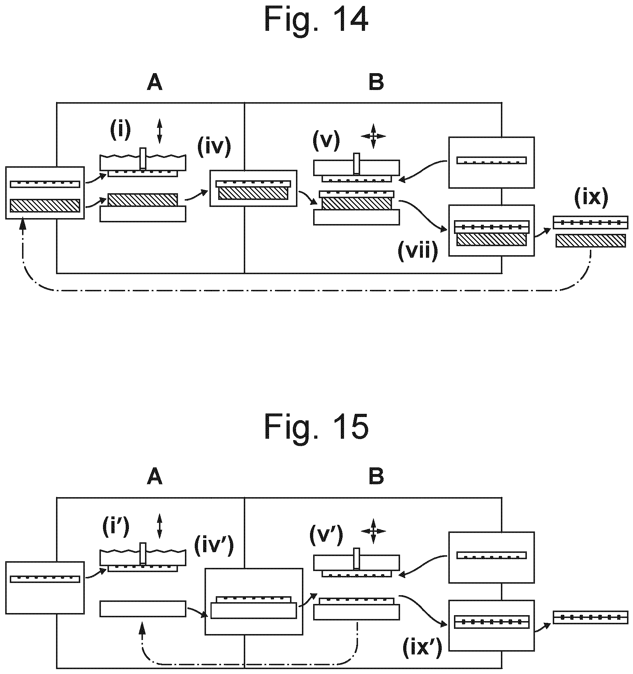

Figure 14 depicts an example manufacturing setup for performing the bonding method according to the second embodiment. The manufacturing setup comprises two stations: Station A, at which the first substrate 110 is bonded to the auxiliary member 130 (steps (i)-(iii) in Figures 8A); and Station B, at which the second substrate 120 is bonded to the first substrate 110 (see steps (v)-(vii) Figure 9A). The roman numerals in Figure 14 correspond to the steps indicated by roman numerals in Figures 8A and 9A so as to indicate which steps are performed at which station. Station A may comprise a clamp apparatus (i.e. a first clamp 170 and a second clamp 180). Station B may comprise a clamp apparatus (i.e. a first clamp 170 and a second clamp 180).

Stations A and B may be configured to perform their respective operations simultaneously. Consequently, a throughput of the manufacturing method can be increased (as compared to the case where a single station with a single clamp apparatus is used for performing bonding method according to the second embodiment).

At Station A, only coarse alignment may be required between the first substrate 110 and the auxiliary member 130. At Station B, finer alignment of the second substrate 120 and the first substrate 110 may be required to ensure that the metallic portions 125 of the second substrate 120 and the metallic portions 115 of the first substrate 110 align once the two substrates 110, 120 are bonded together. Consequently, Station B may be provided with a fine X, Y and Z stage which allows the second clamp 180 to be precisely moved.

Figure 15 shows a manufacturing setup for performing the bonding method according to the modified version of the second embodiment. The manufacturing setup depicted in Figure 15 may comprise two stations (Station A and Station B), as has been described in relation to Figure 14.

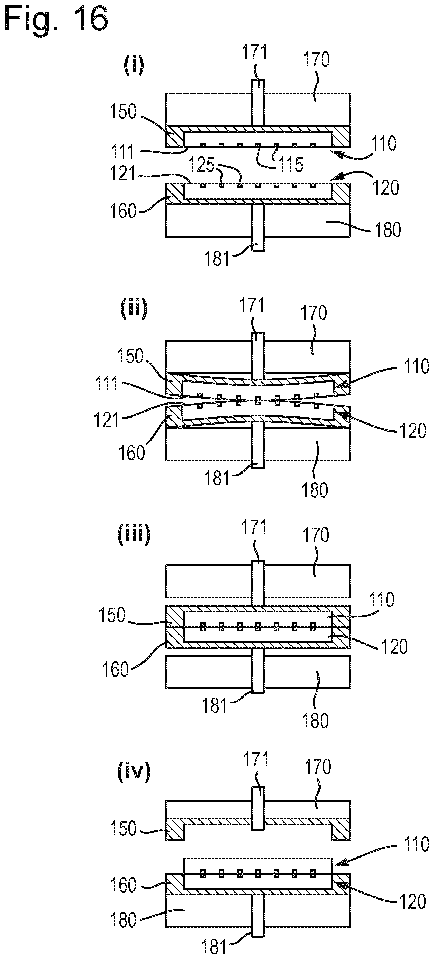

A third embodiment of the present disclosure will now be described with reference to Figure 16. The third embodiment of the present disclosure may be useful for mitigating unpredictable/uncontrollable edge roll-off behaviour in a bonding method. The third embodiment of the present disclosure may be combined with the first and/or second embodiments of the present disclosure. The third embodiment may also be implemented independently (i.e. without the features of the first and/or second embodiments of the present disclosure).

In the conventional method depicted in Figure 4A, where the first substrate 110 is clamped to the first clamp 170, the pin 171 of the first clamp 170 pushes against a radially inward portion (e.g. a radially central portion) the back surface 112. This causes the radially inward portion of the back surface 112 of the first substrate 110 to break contact with the clamping surface 172 of the first clamp 170. This is shown in step (ii) in Figure 4A. The breaking of the contact between the back surface 112 of the first substrate 110 and the first clamp 170 then spreads radially outward. Therefore, a radially outward portion (i.e. an edge portion) of the back surface 112 of the first substrate 110 breaks contact with the clamping surface 172 of the clamp 170 last.

The point at which the radially outward portion of the back surface 112 of the first substrate 110 loses contact with the clamping surface 172 of the first clamp 170 is referred to as the edge roll-off. The edge roll-off may be unpredictable and uncontrollable. Thus, the edge roll-off may introduce unpredictable and uncontrollable distortions into the first substrate 110 as it is pushed away from the first clamp 170 by the pushing means 171. The bonding method according to the third embodiment of the present disclosure provides a means of decoupling the unpredictable/uncontrollable edge roll-off behaviour from the distortion of the substrate.

An example of the bonding method according to the third embodiment is depicted in Figure 16. As depicted in step (i) in Figure 16, the bonding method according to the third embodiment comprises use of a first clamp 170 and a second clamp 180. The first clamp 170 and/or the second clamp 180 be substantially similar to the first clamp 170 and the second clamp 180 described with reference to the previous embodiments. In the example depicted in Figure 16, the second clamp 180 comprises a pushing means. The pushing means of the second clamp 180 may comprise a pin 181. The pin 181 may be configured to extend through the main body of the second clamp 180. The pin 181 of the second clamp 180 may be substantially the same as the pin 171 of the first clamp 170 (except for the fact that the two pins are configured to apply forces to the substrates 110, 120 in opposite directions).

The apparatus further comprises an auxiliary member 150, 160 for each of the substrates 110, 120 that are being bonded. That is, the apparatus comprises a first auxiliary member 150 for the first substrate 110, and a second auxiliary member 160 for the second substrate 120. The auxiliary members may function as intermediate clamps.

The first auxiliary member 150 may be clamped to the first clamp 170. The first substrate 110 may be secured to the first auxiliary member 150. The first substrate 110 may be secured to the first auxiliary member 150 through any suitable means. For example, the first substrate 110 may be bonded to the first auxiliary member 150 (e.g. through Van der Waal's forces and the like). Additionally or alternatively, the first substrate 110 may be clamped to the first auxiliary member 150 by a suitable clamping means (e.g. electrostatic clamping).

The second auxiliary member 160 may be clamped to the second clamp 180. The second substrate 120 may be secured to the second auxiliary member 160. Like the first substrate 110 and the first auxiliary member 150, the second substrate 120 may be secured to the second auxiliary member 160 through any suitable means (e.g. through Van der Waal's forces and the like). Additionally or alternatively, the second substrate 120 may be clamped to the second auxiliary member 160 (e.g. using electrostatic clamping).

As shown in Figure 16, the diameter of the first auxiliary member 150 may be greater than a diameter of the first substrate 110. For example, the diameter of the first auxiliary member 150 may be greater than 100% of the diameter of the first substrate 110, optionally greater than 105% of the diameter of the first substrate 110, and optionally greater than 110% of the diameter of the first substrate 110. The first substrate 110 may be arranged on the first auxiliary member 150 such that a circumferential edge of the first auxiliary member 150 is radially outward of the circumferential edge of the first substrate 110. The first substrate 110 and the first auxiliary member 150 may be concentric.

Similarly, a diameter of the second auxiliary member 160 may be greater than a diameter of the second substrate 120. For example, the diameter of the second auxiliary member 160 may be greater than 100% of the diameter of the second substrate 120, optionally greater than 105% of the diameter of the second substrate 120, optionally greater than 110% of the diameter of the second substrate 120. The second substrate 120 may be arranged on the second auxiliary member 160 such that a circumferential edge of the second auxiliary member 160 is radially outward of the circumferential edge of the second substrate 120. The second substrate 120 and the second auxiliary member 160 may be concentric.

As shown in step (ii) of Figure 16, to initiate clamping of the first substrate 110 and the second substrate 120, the pin 171 in the first clamp 170 is extended and the pin 181 in the second clamp 180 is extended. The extension of the pin 171 of the first clamp 170 may occur simultaneously with the extension of the pin 181 of the second clamp 180.

The extension of the pin 171 of the first clamp 170 may cause the pin 171 to exert a force on a back surface of the auxiliary member 150. Consequently, the first auxiliary member 150 may be pushed away from the first clamp 170. The extension of the pin 181 in the second clamp 180 may cause the pin 181 to exert force on a back surface of the second auxiliary member 160. Consequently, the second auxiliary member 160 may be pushed away from the second clamp 180.

Because the first substrate 110 is supported on the first auxiliary member 150, pushing the first auxiliary member 150 away from the first clamp 170 results in the first substrate 110 being pushed away from the first clamp 170. Similarly, because the second substrate 120 is supported on the second auxiliary member 160, pushing the second auxiliary member 160 away from the second clamp 180 results in the second substrate 120 being pushed away from the second clamp 180. Thus, by pushing the first and second auxiliary members 150, 160 as described above, the first substrate 110 and the second substrate 120 are brought into contact with one another. Thus, by pushing the first and second auxiliary members 150, 160 as described above, bonding (e.g. through Van der Waal's forces and the like) is initiated.

As the first and second substrates 110, 120 are brought together (by pushing the first and second auxiliary members 150, 160), initially, a central region of the bonding surface 111 of the first substrate 110 comes into contact with a central region of the bonding surface 121 of the second substrate 120 (see Figure 16(ii)). The contact between the bonding surfaces 111, 121 of the first substrate 110 and the second substrate 120 then propagates radially outward as the forces (e.g. Van der Waal's forces) between the bonding surfaces 111, 121 pull the bonding surfaces 111, 121 towards one another.

The pin 171 of the first clamp 170 pushes against a radially inward portion (i.e. a radially central portion) of the back surface of the first auxiliary member 150. This causes the radially inward portion of the back surface of the first auxiliary member 150 to break contact with the clamping surface 172 of the first clamp 170. The breaking of the contact between the back surface of the first auxiliary member 150 and the first clamp 170 then spreads radially outward. Consequentially, a radially outward portion (i.e. an edge portion or a perimeter portion) of the back surface of the first auxiliary member 150 breaks contact with the clamping surface 172 of the first clamp 170 last. The breaking of the contact between the radially outward portion of the back surface of the first auxiliary member 150 and the clamping surface 172 of the first clamp 170 may be referred to as edge roll off. This edge roll-off behaviour may be unpredictable/uncontrollable. The edge roll-off behaviour may be exhibited during the pushing of the second auxiliary member 160 by the second clamp 180.

At the time at which the edge portion of the first auxiliary member 150 rolls off the first clamp 170, a majority of the first substrate 110 may already be in contact with the second substrate 120. For example, at the time at which the edge portion of the first auxiliary member 150 rolls off the first clamp 170, 90% by area of the bonding surface 111 of the first substrate 110 may already be in contact with the bonding surface 121 of the second substrate 120. For example, at the time at which the edge portion of the first auxiliary member 150 rolls off the first clamp 170, substantially all of the bonding surface 111 of the first substrate 110 may be in contact with the bonding surface 121 of the second substrate 120. This may be because the first auxiliary member 150 has a greater diameter than the first substrate 110. Consequently, the edge roll-of (of the first auxiliary member 150 from the first clamp 170) is delayed until after the first and second substrates 110, 120 are in contact (and bonded together by, e.g. Van der Waal's forces). Consequentially, the unpredictable/uncontrollable roll-off behaviour of the first auxiliary member 150 as it breaks contact with the first clamp 170 does not have an impact on the (distortion of) the first substrate 110.

Similarly, at the time at which the edge portion of the second auxiliary member 160 rolls off the second clamp 180, a majority of the second substrate 120 may already be in contact with the first substrate 110. For example, at the time at which the edge portion of the second auxiliary member 160 rolls off the second clamp 180, 90% by area of the bonding surface 121 of the second substrate 120 may already be in contact with the bonding surface 111 of the first substrate 110. For example, at the time at which the edge portion of the second auxiliary member 160 rolls off the second clamp 180, substantially all of the bonding surface 121 of the second substrate 120 may be in contact with the bonding surface 111 of the first substrate 110. Consequently, the unpredictable/uncontrollable roll-off behaviour of the second auxiliary member 160 as it breaks contact with the second clamp 180 does not have an impact on the (distortion of) the second substrate 120.

The clamping force exerted on the first auxiliary member 150 by the first clamp 170 may be maintained during at least a portion of the time in which the first and second substrates 110, 120 are being brought together. Similarly, the clamping force exerted on the second auxiliary member 160 by the second clamp 180 may be maintained during at least a portion of the time in which the first and second substrates 110, 120 are being brought together. For example, at step (ii) in Figure 16(ii), the first clamp 170 may be exerting a clamping force on the first auxiliary member 150, and the second clamp 180 may be exerting a clamping force on the second auxiliary member 160. Maintaining the clamping force on an auxiliary member may prevent that auxiliary member from rolling off the clamp. Thus, by maintaining the clamping forces, it can be ensured that the auxiliary members 150, 160 do not roll off the clamps before the first and second substrates 110, 120 are mostly in contact.

In some cases, maintaining the clamping force in this way may not be essential, and that the auxiliary members 150, 160 do not roll off the clamps before the first and second substrates 110, 120 are mostly in contact may arise inherently from the auxiliary members 150, 160 having a larger diameter than the substrates 110, 120.

In step (iii) in Figure 16, the first substrate 110 and the second substrate 120 are fully bonded together. In step (iii) in Figure 16, the first auxiliary member 150 is fully separated from the first clamp 170 and the second auxiliary member 160 is fully separated from the second clamp 180. To allow full separation of the auxiliary members 150, 160 from their respective clamps, the clamping force exerted on the auxiliary member 150, 160 by the clamps 170, 180 may be removed.

In step (iv) in Figure 16, the first clamp 170 and the first auxiliary member 150 are withdrawn. At the end of the bonding method according to the third embodiment, the bonded first and second substrates 110, 120 may be removed from the second auxiliary member. To re-start the bonding method (with a different first substrate and second substrate), the auxiliary members 150, 160 may be re-clamped to the clamps 170, 180.

In the method depicted in Figure 16, the first substrate 110 and the second substrate 120 each experience the same or similar pushing as a result of the first clamp 170 being provided with the pin 171 and the second clamp 180 being provided with the pin 181. This means that any distortion (e.g. radial expansion) of the first substrate 110 during the pushing may be matched by corresponding distortion (e.g. radial expansion) of the second substrate 120 during the pushing. Consequently, alignment of the metallic portions 115 of the first substrate 110 and the metallic portions 125 of the second substrate 120 may be improved.

However, it is not necessary to have this symmetrical pushing for the mitigation of the unpredictable/uncontrollable edge roll-off behaviour. For example, a variant of the method depicted in Figure 16 may comprise pushing with only one of the first clamp 170 and the second clamp 180. For example, in a variant of the method depicted in Figure 16, the first clamp 170 may comprise the pushing means (e.g. the pin 171) and the second clamp 180 may not comprise a pushing means. In such a variant of the method, the second substrate may remain clamped to the second clamp 180, and stationary relative to the second clamp 180, throughout the bonding of the first substrate 110 and the second substrate 120. In the variant, the effects of the unpredictable/uncontrollable edge roll off behaviour are still mitigated by the first auxiliary member 150 provided between the first substrate 110 and the first clamp 170. Of course, in another variant, the second clamp 180 may comprise the pushing means (e.g. the pin 181) and the first clamp 170 may not comprise a pushing means.

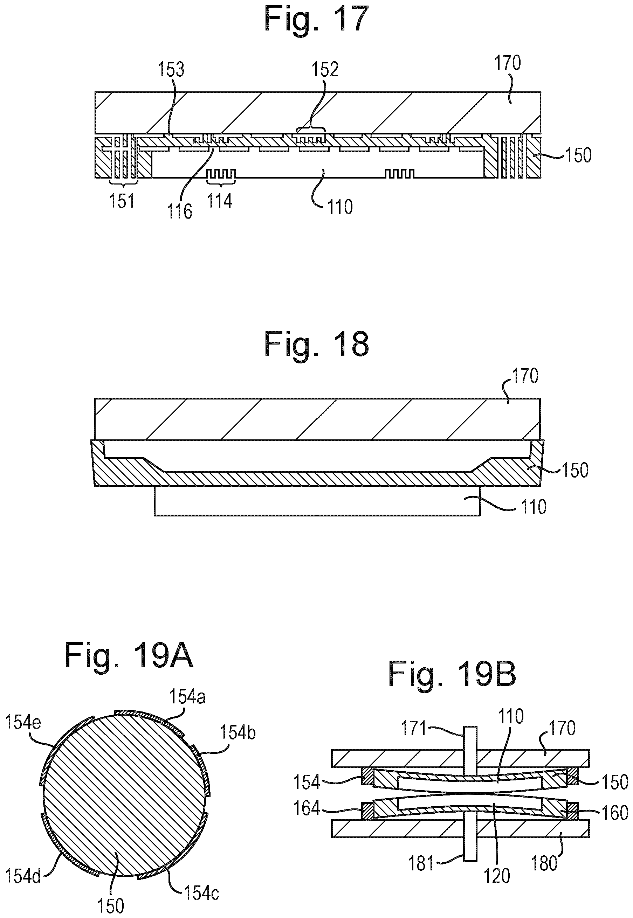

Figure 17 depicts the first clamp 170, the first auxiliary member 150, and the first substrate 110. The arrangement depicted in Figure 17 may be arranged to perform the method according to the third embodiment. The first substrate 110 comprises one or more alignment marks 114 formed thereon (e.g. on the bonding surface 111 of the first substrate 110). The one or more alignment marks 114 on the first substrate 110 may comprise three or more alignment marks 114.

The first auxiliary member 150 may comprise one or more alignment marks 151 formed on a support surface of the first auxiliary member 150 (i.e. on a surface at which the first substrate 110 is secured). The one or more alignment marks 151 on the first auxiliary member 150 may comprise three or more alignment marks. By measuring the (positions of the) one or more alignment marks 114 on the bonding surface 111 of the first substrate 110 and measuring the (positions of the) one or more alignment marks 151 on the support surface of the first auxiliary member 150, the position of the first substrate 110 can be determined relative to the position of the first auxiliary member 150.

The first auxiliary member 150 may comprise one or more alignment marks 152 on a back surface thereof (i.e. a surface opposite the support surface, i.e. a surface which faces the clamp 170). The first clamp 170 may be at least partially transparent to allow for the measurement of the (position of the) one or more alignment marks on the back surface 152 of the auxiliary member 150. The one or more alignment marks 152 on the back surface may be used for the alignment of the first auxiliary member 150 (e.g. the alignment of the first auxiliary member 150 with the second auxiliary member 160). By aligning the first auxiliary member 150, the first substrate 110 can be aligned (e.g. aligned with the second substrate 120). This is because the position of the substrate 150 relative to the auxiliary member 150 is can be determined as described above.

In the bonding method according to the third embodiment, the first substrate may be secured to an inner portion of the first auxiliary member 150. An outer portion of the first auxiliary member 150 may be radially outward of the inner portion. A stiffness of the outer portion of the first auxiliary member 150 may be greater than a stiffness of the inner portion of the first auxiliary member 150. This is shown schematically in Figure 18. The increased stiffness of the outer portion of the first auxiliary member may compensate for the absence of the first substrate 110 at the outer portion of the first auxiliary member 150. For example, a stiffness of the combination of the first auxiliary member 150 and the first substrate may be made to be substantially uniform by increasing the stiffness of the first auxiliary member 150 where the first substrate 110 is not present. The second auxiliary member 160 may be arranged in the same (or a corresponding) way.

During the bonding method according to the third embodiment, the auxiliary members 150, 160 may remain attached to the first and second clamps 170, 180. This may allow throughput to be increased, because it is easier to re-clamp the auxiliary members 150, 160 if some attachment between the auxiliary members 150, 160 and the clamps 170, 180 remains at the termination of an instance of the method.

During the pushing of the first auxiliary member 150 away from the first clamp 170 and towards the second substrate 120 (e.g. to bring the first substrate 110 into contact with the second substrate 120), one or more forces may be applied to the first auxiliary member 150. The one or more forces may be applied using one or more actuators 154, as shown in Figures 19A and 19B. The one or more actuators 154 may be mounted on or otherwise in contact with the first auxiliary member. The one or more forces applied to the first auxiliary member 150 may change an effective stiffness of the first auxiliary member 150.

The applying of the one or more forces to the first auxiliary member 150 may be to control a shape of the first substrate 110 during the bonding method. Additionally or alternatively, the applying of the one or more forces to the first auxiliary member 150 may be to control the separation of the first auxiliary member 150 from the first clamp. The applying of the one or more forces to the first auxiliary member 150 may allow for overlay correction. The applying of the one or more forces to the first auxiliary member may allow some control of the bond wave. Thus, by applying the one or more forces to the first auxiliary member, it may be possible to make the bond wave a desired circular shape.

The one or more actuators 154 may comprise a plurality of actuators 154a-154e. The plurality of actuators 154a-e may be mounted to a circumferential edge of the first auxiliary member 150. The plurality of actuators 154a-e may be separated from one another in the circumferential direction, e.g. such that each actuator follows a different arc of the circumference of the first auxiliary member 150. The plurality of actuators may comprise two or more actuators, four or more actuators, or six or more actuators. Providing actuators in this way may allow for fine control of the shape of the first auxiliary member (and therefore fine control of the shape of the first substrate 110 during the bonding method, and/or fine control of the separation of the first auxiliary member 150 from the first clamp 170).

One or more actuators 164 may be provided to apply forces to the second auxiliary member 160. The one or more actuators 164 be provided to apply forces to the second auxiliary member 160 may be configured in a similar way to the one or more actuators 154 provided to apply forces to the first auxiliary member 150.

Further embodiments of the invention are disclosed in the list of numbered clauses below:
1. A method of joining a first semiconductor substrate and a second semiconductor substrate, the method comprising:
   first pushing the first semiconductor substrate towards an auxiliary member to bring the first semiconductor substrate into contact with the auxiliary member; and then
   second pushing the second semiconductor substrate towards the first semiconductor substrate and the auxiliary member to cause joining of the first semiconductor substrate and the second semiconductor substrate,
   wherein the first pushing is substantially the same as the second pushing.
2. The method of clause 1, wherein the first pushing induces a deformation in the first semiconductor substrate, and the second pushing induces a deformation in the second semiconductor substrate, wherein the deformation in the first semiconductor substrate is substantially the same as the deformation in the second semiconductor substrate.
3. The method of clause 1 or 2, wherein a first pushing mechanism used in the first pushing has a configuration which is substantially the same as a second pushing mechanism used in the second pushing.
4. The method of clause 3, wherein the first pushing mechanism is the same as the second pushing mechanism, or wherein the first pushing mechanism is distinct from the second pushing mechanism.
5. The method of clause 3 or 4, wherein the first pushing mechanism and the second pushing mechanism each comprises one or more extensible pins, and the pins of the first and second pushing mechanism are correspondingly arranged.
6. The method of any of clauses 3 to 5, wherein:
   during the first pushing, the first pushing mechanism pushes against a central portion of the first semiconductor substrate; and/or
   during the second pushing, the second pushing mechanism pushes against a central portion of the second semiconductor substrate, wherein the central portion of the second semiconductor substrate corresponds to the central portion of the first semiconductor substrate.
7. The method of any of the preceding clauses, wherein the pushing of the first semiconductor substrate towards the auxiliary member to bring the first semiconductor substrate into contact with the auxiliary member initiates bonding between the first semiconductor substrate and the auxiliary member, optionally wherein the bonding is optical bonding.
8. The method of any of the preceding clauses, wherein:
   the first semiconductor substrate comprises a plurality of metallic portions provided at a joining surface thereof;
   the first semiconductor substrate comprises a back surface opposite the joining surface;
   the second semiconductor substrate comprises a plurality of metallic portions provided at a joining surface thereof; and
   the second semiconductor substrate comprises a back surface opposite the joining surface.
9. The method of clause 8, wherein:
   the plurality of metallic portions of the first semiconductor substrate are recessed below the joining surface of the first semiconductor substrate; and/or
   the plurality of metallic portions of the second semiconductor substrate are recessed below the joining surface of the second semiconductor substrate.
10. The method of clause 8 or 9, further comprising, after the second pushing, heating at least the first semiconductor substrate and the second semiconductor substrate,
   optionally wherein the heating of at least the first semiconductor substrate and the second semiconductor substrate expands the metallic portions of the first semiconductor substrate and/or the metallic portions of the second semiconductor substrate, causing the metallic portions of the first semiconductor substrate to come into electrical contact with the metallic portions of the second semiconductor substrate.
11. The method of any of clauses 8 to 10, wherein the second pushing comprises bringing the second semiconductor substrate into contact with the first semiconductor substrate.
12. The method of clause 11, wherein the bringing of the second semiconductor substrate into contact with the first semiconductor substrate initiates bonding between the second semiconductor substrate and the first semiconductor substrate, optionally wherein the bonding is optical bonding.
13. The method of clause 11 or 12, wherein the first pushing comprises:
   pushing against the joining surface of the first semiconductor substrate; and/or
   bringing the back surface of the first semiconductor substrate into contact with the auxiliary member.
14. The method of clause 13, wherein first pushing comprises pushing against the joining surface of the first semiconductor substrate with the one or more pins of the first pushing mechanism, and
   optionally, during the pushing against the joining surface of the first semiconductor substrate with the one or more pins, distal ends of each of the one or more pins are separated from the joining surface of the first semiconductor substrate by a flow of gas.
15. The method of any of clauses 11 to 14, wherein the second pushing comprises:
   pushing against the back surface of the second semiconductor substrate; and/or
   bringing the joining surface of the second semiconductor substrate into contact with the joining surface of the first semiconductor substrate.
16. The method of any of clauses 11 to 15, further comprising, after joining the first semiconductor substrate and the second semiconductor substrate, separating the auxiliary member from the first semiconductor substrate.
17. The method of clause 16, wherein the separating of the auxiliary member from the first semiconductor substrate comprises one or more of
   directing a flow of gas towards the back surface of the first semiconductor substrate, optionally wherein the flow of gas is directed by one or more conduits defined in the auxiliary member;
   pushing the first semiconductor substrate away from the auxiliary member by extending one or more auxiliary pins, optionally wherein the one or more auxiliary pins extend through one or more channels defined in the auxiliary member;
   heating at least the first semiconductor substrate and the auxiliary member to expand one or more expanding portions provided at the surface of the auxiliary member which is in contact with the first semiconductor substrate, wherein the one or more expanding portions have a higher thermal expansion coefficient than a main body of the auxiliary member.
18. The method of any of clauses 11 to 17, further comprising, before the first pushing, clamping the first semiconductor substrate to a clamp, optionally wherein the clamp is a vacuum clamp.
19. The method of clause 18, wherein, when the first semiconductor substrate is clamped to the clamp, the first semiconductor substrate is spaced apart from the clamp by one or more flows of gas between the first semiconductor substrate and the clamp.
20. The method of clause 18 or 19, wherein, when the first semiconductor substrate is clamped to the clamp, a functional region of the joining surface of the first semiconductor substrate is separated from the clamp by an edge protrusion provided on the clamp, wherein the edge protrusion contacts the joining surface of the first semiconductor substrate in a region radially outward of the functional region.
21. The method of clause any of clauses 11 to 20, wherein a surface of the auxiliary member with which the first semiconductor substrate comes into contact is formed of a material having substantially similar properties to the first semiconductor substrate,
   optionally wherein the surface of the auxiliary member with which the first semiconductor substrate comes into contact is formed by a coating which is provided on a main body of the auxiliary member.
22. The method of any of clauses 8 to 10, wherein the auxiliary member comprises a plurality of metallic portions at a support surface thereof, and the first pushing comprises bringing the joining surface of the first semiconductor substrate into contact with the support surface of the auxiliary member.
23. The method of clause 22, wherein an arrangement of the plurality of metallic portions at the surface of the auxiliary member is substantially the same as an arrangement of the plurality of metallic portions at the surface of the first semiconductor after a deformation of the first semiconductor substrate during the pushing of the first semiconductor substrate towards the auxiliary member.
24. The method of clause 22 or 23, further comprising removing material from the auxiliary member,
   optionally wherein the removing of material from the auxiliary member is such that the plurality of metallic portions of the auxiliary member are exposed at a back surface of the auxiliary member, wherein the back surface of the auxiliary member is opposite the support surface of the auxiliary member.
25. The method of clause 24, wherein the second pushing comprises bringing the joining surface of the second semiconductor substrate into contact with the back surface of the auxiliary member.
26. The method of clause 25, wherein the bringing of the joining surface of the second semiconductor substrate into contact with the back surface of the auxiliary member initiates bonding between the second semiconductor substrate and the auxiliary member, optionally wherein the bonding is optical bonding.
27. The method of any of clauses 22 to 25, further comprising, after the bringing of the joining surface of the second semiconductor substrate into contact with the back surface of the auxiliary member, heating at least the first semiconductor substrate, the auxiliary member and the second semiconductor substrate to expand the metallic portions of first semiconductor substrate, the auxiliary member and the second semiconductor substrate, causing the metallic portions of the first semiconductor substrate to become electrically connected to the metallic portions of the second semiconductor substrate via the metallic portions of the auxiliary member.
28. The method of any of clauses 25 to 27, further comprising, after the bringing of the joining surface of the first semiconductor substrate into contact with the support surface of the auxiliary member, affixing a bracing member to the back surface of the first semiconductor substrate,
   optionally wherein the bracing member is configured to prevent deformation of the first semiconductor substrate and the auxiliary member during and after the removing of material from the auxiliary member.
29. The method of clause 28, further comprising, after joining the first semiconductor substrate and the second semiconductor substrate, separating the bracing member from the first semiconductor substrate.
30. The method of clause 29, wherein the separating of the bracing member from the first semiconductor substrate comprises one or more of:
   directing a flow of gas towards the back surface of the first semiconductor substrate, optionally wherein the flow of gas is directed by one or more conduits defined in the bracing member;
   pushing the first semiconductor substrate away from the bracing member by extending one or more bracing pins, optionally wherein the one or more bracing pins extend through one or more channels in the bracing member;
   heating at least the first semiconductor substrate and the bracing member to expand one or more expanding portions provided at the surface of the bracing member which is in contact with the first semiconductor substrate, wherein the one or more expanding portions have a higher thermal expansion coefficient than a main body of the bracing member.
31. A system for joining a first semiconductor substrate and a second semiconductor substrate, the system comprising:
   a clamp;
   a pushing mechanism; and
   an auxiliary member,
   wherein the system is configured to perform the method of any of the preceding clauses.
32. A system for joining a first semiconductor substrate and a second semiconductor substrate, the system comprising:
   a first pushing mechanism configured to push the first semiconductor substrate towards an auxiliary member to bring the first semiconductor substrate into contact with the auxiliary member;
   a second pushing mechanism configured to push the second semiconductor substrate towards the first semiconductor substrate and the auxiliary member to cause joining of the first semiconductor substrate and the second semiconductor substrate,
   wherein the first pushing mechanism is substantially the same as the second pushing mechanism.
33. A computer program comprising instructions to cause the system of clauses 31 or 32 to execute the steps of the method of any of clauses 1 to 30.
34. A method of bonding a first semiconductor substrate and a second semiconductor substrate, the method comprising:
   clamping an auxiliary member to a clamp, wherein the first semiconductor substrate is secured to the auxiliary member; and
   pushing the auxiliary member away from the clamp and towards the second semiconductor substrate to bring the first semiconductor substrate into contact with the second semiconductor substrate, wherein a perimeter portion of the auxiliary member remains in contact with the clamp until more than 90% by area of a joining surface of the first semiconductor substrate is in contact with a joining surface of the second semiconductor substrate.
35. The method of clause 34, wherein the perimeter portion of the auxiliary member remains in contact with the clamp until substantially all of the joining surface of the first semiconductor substrate is in contact with the joining surface of the second semiconductor substrate.
36. The method of clause 34 or 35, wherein the bringing of the first semiconductor substrate into contact with the second semiconductor substrate initiates bonding between the first semiconductor substrate and the second semiconductor substrate, optionally where the bonding is optical bonding.
37. The method of any of clauses 34 to 36, wherein the pushing of the auxiliary member away from the clamp comprises extending one or more pins from within the clamp.
38. The method of any of clauses 34 to 37, further comprising, after bringing the first semiconductor substrate into contact with the second semiconductor substrate, separating the first semiconductor substrate from the auxiliary member.
39. The method of any of clauses 34 to 38, wherein the first semiconductor substrate is secured to an inner portion of the auxiliary member, and an outer portion of the auxiliary member is radially outward of the inner portion, and a stiffness of the outer portion is greater than a stiffness of the inner portion.
40. The method of any of clauses 34 to 39, further comprising, during the pushing of the auxiliary member away from the clamp and towards the second semiconductor substrate to bring the first semiconductor substrate into contact with the second semiconductor substrate, applying one or more forces to the auxiliary member using one or more actuators,
   optionally wherein the applying of the one or more forces to the auxiliary member is to control a shape of the first semiconductor substrate and/or to control the separation of the auxiliary member from the clamp.
41. The method of any of clauses 34 to 40, further comprising determining a position of the first semiconductor substrate relative to the auxiliary member using one or more alignment marks on the first semiconductor substrate and one or more alignment marks on the auxiliary member,
   optionally wherein the one or more alignment marks on the first semiconductor substrate comprises three or more alignment marks and/or the one or more alignment marks on the auxiliary member comprises three or more alignment marks.
   The method of clause 41, wherein some or all of the alignment marks on the auxiliary member are formed on a surface of the auxiliary member which faces the clamp, optionally wherein the clamp is transparent.
42. The method of any of clauses 34 to 42, wherein:
   the auxiliary member to which the first semiconductor substrate is secured is a first auxiliary member, and the second semiconductor substrate is secured to a second auxiliary member;
   the method comprises aligning the first auxiliary member and the second auxiliary member; and
   the aligning of the first auxiliary member and the second auxiliary member comprises use of one or more alignment marks on the first auxiliary member and one or more alignment marks on the second auxiliary member.
43. The method of any of clauses 34 to 43, wherein the method comprises:
   clamping a first auxiliary member to a first clamp, wherein the first semiconductor substrate is secured to the first auxiliary member;
   clamping a second auxiliary member to a second clamp, wherein the second semiconductor substrate is secured to the second auxiliary member;
   pushing the first auxiliary member away from the first clamp and towards the second semiconductor substrate, and pushing the second auxiliary member away from the second clamp and towards the first semiconductor substrate; and
   by the pushing of the first auxiliary member away from the first clamp and the pushing of the second auxiliary member away from the second clamp, bringing the first semiconductor substrate into contact with the second semiconductor substrate,
   wherein a perimeter portion of the first auxiliary member remains in contact with the first clamp until more than 90% by area of a joining surface of the first semiconductor substrate is in contact with a joining surface of the second semiconductor substrate, and/or wherein a perimeter portion of the second auxiliary member remains in contact with the second clamp until more than 90% by area of the joining surface of the second semiconductor substrate is in contact with the joining surface of the first semiconductor substrate.
44. A system for use in bonding a first semiconductor substrate to a second semiconductor substrate, the system comprising:
   a clamp;
   an auxiliary member; and
   a pushing mechanism,
   wherein the system is configured to perform the method of any of clauses 34 to 44.
45. A system for use in bonding semiconductor substrates, the system comprising:
   an auxiliary member configured to support a semiconductor substrate;
   a clamp configured to releasably clamp the auxiliary member; and
   a pushing mechanism configured to push the auxiliary member and the semiconductor substrate supported thereon away from the clamp,
   wherein a diameter of the auxiliary member is greater than a diameter of the semiconductor substrate.
46. The system of clause 46, wherein the diameter of the auxiliary member is greater than 100% of the diameter of the semiconductor substrate, optionally greater than 105% of the diameter of the semiconductor substrate, optionally greater than 110% of the diameter of the semiconductor substrate.
47. The system of clause 46 or 47, wherein the diameter of the auxiliary member is greater than 320 mm, optionally greater than 340 mm.
48. A computer program comprising instructions to cause the system of clauses 45 to 48 to execute the steps of the method of any of clauses 34 to 44.
49. The method of any of clauses 1 to 32 and 34 to 44, further comprising performing lithographic patterning and/or processing on the back surface of the first semiconductor substrate and/or performing lithographic patterning and/or processing on the back surface of the second semiconductor substrate.
50. The method of any of clauses 1 to 32, 34 to 44 and 50, wherein:
   the first semiconductor substrate and/or the second semiconductor substrate is/are a semiconductor wafer, optionally wherein the semiconductor wafer has a diameter of approximately 300 mm; or
   the first semiconductor substrate and/or the second semiconductor substrate is/are a die.
51. An assembly comprising the first semiconductor substrate and the second semiconductor substrate, wherein the first semiconductor substrate and the second semiconductor substrate are joined to one another using the method of any of clauses 1 to 32, 34 to 44 and 50 to 51.
52. An electronic device comprising the assembly of clause 52.

The terms "radiation" and "beam" used in relation to the lithographic apparatus encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

## Claims

1. A method of joining a first semiconductor substrate and a second semiconductor substrate, the method comprising:
first pushing the first semiconductor substrate towards an auxiliary member to bring the first semiconductor substrate into contact with the auxiliary member; and then
second pushing the second semiconductor substrate towards the first semiconductor substrate and the auxiliary member to cause joining of the first semiconductor substrate and the second semiconductor substrate,
wherein the first pushing is substantially the same as the second pushing.

2. The method of claim 1, wherein the first pushing induces a deformation in the first semiconductor substrate, and the second pushing induces a deformation in the second semiconductor substrate, wherein the deformation in the first semiconductor substrate is substantially the same as the deformation in the second semiconductor substrate.

3. The method of claim 1, wherein a first pushing mechanism used in the first pushing has a configuration which is substantially the same as a second pushing mechanism used in the second pushing.

4. The method of claim 3, wherein the first pushing mechanism is the same as the second pushing mechanism, or wherein the first pushing mechanism is distinct from the second pushing mechanism.

5. The method of claim 3, wherein the first pushing mechanism and the second pushing mechanism each comprises one or more extensible pins, and the pins of the first and second pushing mechanism are correspondingly arranged.

6. The method of claim 3, wherein:
during the first pushing, the first pushing mechanism pushes against a central portion of the first semiconductor substrate; and/or
during the second pushing, the second pushing mechanism pushes against a central portion of the second semiconductor substrate, wherein the central portion of the second semiconductor substrate corresponds to the central portion of the first semiconductor substrate.

7. The method of claim 1, wherein the pushing of the first semiconductor substrate towards the auxiliary member to bring the first semiconductor substrate into contact with the auxiliary member initiates bonding between the first semiconductor substrate and the auxiliary member, optionally wherein the bonding is optical bonding.

8. The method of claim 1, wherein:
the first semiconductor substrate comprises a plurality of metallic portions provided at a joining surface thereof;
the first semiconductor substrate comprises a back surface opposite the joining surface;
the second semiconductor substrate comprises a plurality of metallic portions provided at a joining surface thereof; and
the second semiconductor substrate comprises a back surface opposite the joining surface.

9. The method of claim 8, wherein:
the plurality of metallic portions of the first semiconductor substrate are recessed below the joining surface of the first semiconductor substrate; and/or
the plurality of metallic portions of the second semiconductor substrate are recessed below the joining surface of the second semiconductor substrate.

10. The method of claim 8, further comprising, after the second pushing, heating at least the first semiconductor substrate and the second semiconductor substrate,
optionally wherein the heating of at least the first semiconductor substrate and the second semiconductor substrate expands the metallic portions of the first semiconductor substrate and/or the metallic portions of the second semiconductor substrate, causing the metallic portions of the first semiconductor substrate to come into electrical contact with the metallic portions of the second semiconductor substrate.

11. The method of claim 8, wherein the second pushing comprises bringing the second semiconductor substrate into contact with the first semiconductor substrate.

12. The method of claim 11, wherein the bringing of the second semiconductor substrate into contact with the first semiconductor substrate initiates bonding between the second semiconductor substrate and the first semiconductor substrate, optionally wherein the bonding is optical bonding.

13. The method of claim 11, wherein the first pushing comprises:
pushing against the joining surface of the first semiconductor substrate; and/or
bringing the back surface of the first semiconductor substrate into contact with the auxiliary member.

14. The method of claim 11, wherein the second pushing comprises:
pushing against the back surface of the second semiconductor substrate; and/or
bringing the joining surface of the second semiconductor substrate into contact with the joining surface of the first semiconductor substrate.

15. A system for joining a first semiconductor substrate and a second semiconductor substrate, the system comprising:
a clamp;
a pushing mechanism; and
an auxiliary member,
wherein the system is configured to perform the method of any of claims 1 to 6.
